(19) **Europäisches Patentamt / European Patent Office / Office européen des brevets**

(11) **EP 4 553 515 B1**

(12) **EUROPEAN PATENT SPECIFICATION**

(45) Date of publication and mention
of the grant of the patent:
**01.07.2026 Bulletin 2026/27**

(21) Application number: **23872964.4**

(22) Date of filing: **21.09.2023**

(51) International Patent Classification (IPC):
*G01R 31/36* (2020.01)   *G01R 31/3835* (2019.01)
*G01R 31/392* (2019.01)   *G01R 31/396* (2019.01)
*G01R 19/00* (2006.01)   *G01R 19/165* (2006.01)
*G01R 31/371* (2019.01)   *G01R 31/367* (2019.01)

(52) Cooperative Patent Classification (CPC):
**G01R 31/396; B60L 3/0046; B60L 58/10;
B60L 58/18; G01R 31/367; G01R 31/371;
G01R 31/3835; G01R 31/392;** Y02E 60/10

(86) International application number:
**PCT/KR2023/014441**

(87) International publication number:
**WO 2024/071847 (04.04.2024 Gazette 2024/14)**

(54) **BATTERY DIAGNOSIS APPARATUS, BATTERY DIAGNOSIS METHOD, BATTERY PACK, AND VEHICLE**

BATTERIEDIAGNOSEVORRICHTUNG, BATTERIEDIAGNOSEVERFAHREN, BATTERIEPACK UND FAHRZEUG

APPAREIL DE DIAGNOSTIC DE BATTERIE, PROCÉDÉ DE DIAGNOSTIC DE BATTERIE, BLOC-BATTERIE ET VÉHICULE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **27.09.2022 KR 20220122317**

(43) Date of publication of application:
**14.05.2025 Bulletin 2025/20**

(73) Proprietor: **LG Energy Solution, Ltd.
Seoul 07335 (KR)**

(72) Inventor: **YEOM, In-Cheol
Daejeon 34122 (KR)**

(74) Representative: **Plasseraud IP
104 Rue de Richelieu
CS92104
75080 Paris Cedex 02 (FR)**

(56) References cited:
CN-A- 113 777 515       KR-A- 20160 014 940
KR-A- 20160 085 070   KR-A- 20220 009 258
KR-A- 20220 009 258   KR-A- 20220 045 451
KR-A- 20220 074 797

EP 4 553 515 B1

## Description

<u>TECHNICAL FIELD</u>

The present disclosure relates to a technology for diagnosing a voltage abnormality of a battery.

The present application claims priority to Korean Patent Application No. 10-2022-0122317 filed on September 27, 2022 in the Republic of Korea.

<u>BACKGROUND ART</u>

Recently, there has been a rapid increase in the demand for portable electronic products such as laptop computers, video cameras and mobile phones, and with the extensive development of electric vehicles, energy storage systems, robots and satellites, many studies are being made on high performance batteries that can be recharged repeatedly.

Currently, commercially available batteries include nickel-cadmium batteries, nickel-hydrogen batteries, nickel-zinc batteries, lithium ion batteries and the like. Among them, lithium batteries have little or no memory effect, and thus they are gaining more attention than nickel-based batteries for their advantages that recharging can be done whenever it is convenient, the self-discharge rate is very low and the energy density is high.

Recently, as applications requiring high voltage (e.g., energy storage systems, electric vehicles) become widespread, the need for diagnostic technology that accurately detects voltage abnormalities in each of the plurality of battery cells connected in series within a battery pack is increasing.

The voltage abnormality of a battery cell refers to a fault condition in which the cell voltage drops and/or rises abnormally due to internal short-circuit, external short-circuit, failure of the voltage sensing line, or poor connection with the charging/discharging line.

Conventionally, a simple method was used to diagnose a voltage abnormality of a battery cell by determining whether the difference between cell voltages measured at two different time points exceeds a threshold value. This method has the advantage of not requiring a high-performance processor because the amount of data calculation is not large.

However, since the voltage of a battery cell also depends on temperature, current, and/or SOH (State Of Health) of the battery cell, it is not easy to accurately diagnose the voltage abnormality of the battery cell just through the process of comparing the difference of the voltages of the battery cell measured at different time points with the threshold value.

In addition, if the voltage difference between the battery cells is lower than or equal to the threshold value but the voltage slope of the battery cell shows abnormal behavior, for example, when lithium plating (Li-plating) occurs on the negative electrode of a lithium battery, there is a limit in that an abnormality in cell voltage cannot be detected.

Prior art document CN113777515 discloses an arrangement for diagnosing individual battery cells, involving a matrix comprised of vector (cross) products.

<u>DISCLOSURE</u>

Technical Problem

The present disclosure is designed to solve the problems of the related art, and therefore the present disclosure is directed to providing a battery diagnosis apparatus, a battery diagnosis method, a battery pack, and a vehicle, which may reliably diagnose a battery cell exhibiting a voltage abnormality among a plurality of battery cells through simple mathematical calculation.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

In one aspect of the present disclosure, there is provided a battery diagnosis apparatus, comprising: a voltage sensing circuit configured to generate a voltage signal for each of first to $N^{th}$ battery cells; a storage medium configured to store voltage time series data; and a control circuit operably coupled with the voltage sensing circuit and the storage medium.

The control circuit may (a) receive the voltage signal from the voltage sensing circuit and record first to $N^{th}$ voltage time series data of the first to $N^{th}$ battery cells in the storage medium, (b) select a set of first voltages measured at a first time and a set of second voltages measured at a second time later the first time from the first to $N^{th}$ voltage time series data, (c) determine a coordinate <the first time, an average of the set of first voltages> as a first average position vector and determine a coordinate <the second time, an average of the set of second voltages> as a second average position vector, (d) determine a difference between the first average position vector and the second average position vector as a diagnosis reference vector, (e) for an $i^{th}$ battery cell (i is 1 to N), (i) determine a coordinate <the first time, the first voltage> as a first diagnosis position vector and determine a coordinate <the second time, the second voltage> as a second diagnosis position vector, (ii) determine a difference between the first diagnosis position vector and the second diagnosis position vector as an $i^{th}$ diagnosis vector, and (iii) determine an $i^{th}$ diagnosis factor based on a magnitude of a cross product of the diagnosis reference vector and the $i^{th}$ diagnosis vector, and (f) diagnose the $i^{th}$ battery cell as exhibiting a voltage abnormality when the $i^{th}$ diagnosis factor exceeds a threshold value.

In one aspect, the average of the set of first voltages may be an arithmetic average value or a median value of the set of first voltages, and the average of the set of second voltages may be an arithmetic average value or a median value of the set of second voltages.

In another aspect, the average of the set of first voltages may be an arithmetic average value or a median value of voltage values within β (β is 1 to 3) sigma among voltage values included in the set of first voltages, and the average of the set of second voltages may be an arithmetic average value or a median value of voltage values within β (β is 1 to 3) sigma among voltage values included in the set of second voltages.

The control circuit may be configured to set the threshold value based on the average of the $i^{th}$ diagnosis factors (i is 1 to N).

When the average of the $i^{th}$ diagnosis factors (i is 1 to N) is $m_{ave}$, the control circuit may be configured to set a value corresponding to $m_{ave}*\alpha$ ($\alpha$ is 1 to 10) as the threshold value.

In the present disclosure, a time interval between the first time and the second time may be an integer multiple of a voltage measurement period.

The battery diagnosis apparatus may further comprise an interface unit operably coupled with the control circuit to support communication with an external device. The control circuit may be configured to transmit the result of diagnosing a voltage abnormality for the first to $N^{th}$ battery cells to the external device through the interface unit.

The battery diagnosis apparatus may further comprise an interface unit operably coupled with the control circuit; and an output device operably coupled with the interface unit. The control circuit may be configured to visually or audibly output the result of diagnosing a voltage abnormality for the first to $N^{th}$ battery cells through the output device.

In another aspect of the present disclosure, there is also provided a battery diagnosis method, comprising: (a) generating first to $N^{th}$ voltage time series data of first to $N^{th}$ battery cells from a voltage signal received from a voltage sensing circuit and record the first to $N^{th}$ voltage time series data in a storage medium; (b) selecting a set of first voltages measured at a first time and a set of second voltages measured at a second time later the first time from the first to $N^{th}$ voltage time series data; (c) determining a coordinate <the first time, an average of the set of first voltages> as a first average position vector and determining a coordinate <the second time, an average of the set of second voltages> as a second average position vector, (d) determining a difference between the first average position vector and the second average position vector as a diagnosis reference vector, (e) for an $i^{th}$ battery cell (i is 1 to N), (i) determining a coordinate <the first time, the first voltage> as a first diagnosis position vector and determining a coordinate <the second time, the second voltage> as a second diagnosis position vector, (ii) determining a difference between the first diagnosis position vector and the second diagnosis position vector as an $i^{th}$ diagnosis vector, and (iii) determining an $i^{th}$ diagnosis factor based on a magnitude of a cross product of the diagnosis reference vector and the $i^{th}$ diagnosis vector; and (f) diagnosing the $i^{th}$ battery cell as exhibiting a voltage abnormality when the $i^{th}$ diagnosis factor exceeds a threshold value.

In another aspect of the present disclosure, there is also provided a battery pack comprising the battery diagnosis apparatus described above, and a vehicle comprising the battery pack.

Advantageous Effects

According to the present disclosure, among the plurality of battery cells, a battery cell exhibiting a voltage abnormality may be easily identified and diagnosed through simple mathematical calculation.

According to another embodiment of the present disclosure, since the calculation method used for battery diagnosis is not complicated, a processor with high specification is not required.

According to still another embodiment of the present disclosure, the reliability of voltage abnormality diagnosis may be improved by quantitatively analyzing the difference in voltage change behavior of an abnormal battery cell compared to the average voltage change behavior of battery cells.

According to still another embodiment of the present disclosure, a battery cell that exhibit abnormal voltage behavior may be reliably identified even if the difference between voltages measured at different time points is not large.

The effects of the present disclosure are not limited to the above-mentioned effects, and these and other effects not mentioned herein will be clearly understood by those skilled in the art from the appended claims.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is an exemplary diagram showing a vehicle according to an embodiment of the present disclosure.

FIG. 2a is a graph showing 9 voltage time series data for a total of 9 battery cells according to an embodiment of the present disclosure.

FIG. 2b is a drawing showing a diagnosis reference vector $\vec{v}_{refer,k}*$ determined from a voltage set at a first time ($t_{k*}$) and a second time ($t_{k*+1}$) according to an embodiment of the present disclosure and a diagnosis vector $\vec{v}_{diag\_6,k}*$ for a battery cell #6, together with the graph of FIG. 2a.

FIG. 2c is a graph showing diagnosis factors $J_{1,k*}$, $J_{2,k*}$, $J_{3,k*}$, $J_{4,k*}$, $J_{5,k*}$, $J_{6,k*}$, $J_{7,k*}$, $J_{8,k*}$ and $J_{9,k*}$ determined from a voltage set at the first time ($t_{k*}$) and the second time ($t_{k*+1}$) for a total of 9 battery cells according to an embodiment of the present disclosure.

FIG. 3 is a flowchart for illustrating a battery diagnosis method according to an embodiment of the present disclosure.

BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other modifications could be made thereto without departing from the scope of the disclosure.

The terms including the ordinal number such as "first", "second" and the like, are used to distinguish one element from another among various elements, but not intended to limit the elements by the terms.

Unless the context clearly indicates otherwise, it will be understood that the term "comprises" when used in this specification, specifies the presence of stated elements, but does not preclude the presence or addition of one or more other elements. Also, the component "control circuit" as used herein refers to a processing unit of at least one function or operation, and may be implemented by hardware and software either alone or in combination.

In addition, throughout the specification, it will be further understood that when an element is referred to as being "connected to" another element, it can be directly connected to the other element or intervening elements may be present.

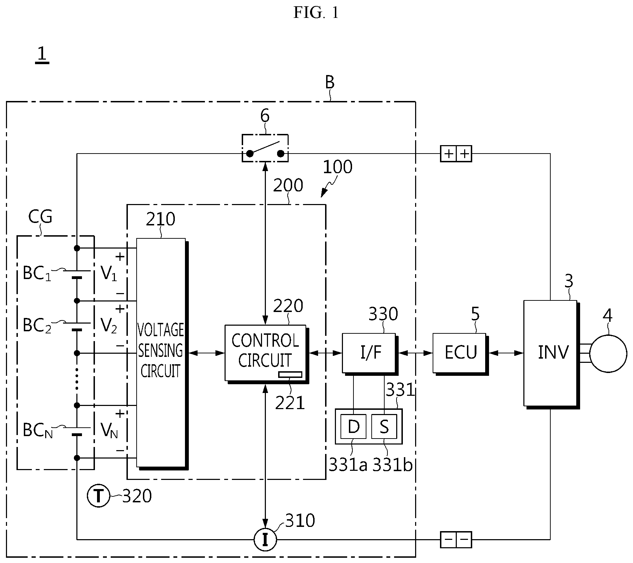

FIG. 1 is an exemplary diagram showing a vehicle according to an embodiment of the present disclosure.

Referring to FIG. 1, the vehicle 1 includes a battery pack B, an inverter 3, an electric motor 4 and a vehicle controller 5.

The vehicle 1 refers to a vehicle that can be driven by a motor using electrical energy provided by the battery pack B. As an example, the vehicle 1 may be an electric vehicle, a plug-in hybrid vehicle, or a hybrid vehicle. The vehicle 1 may be a two-wheeled, three-wheeled or four-wheeled vehicle.

The battery pack B includes a cell group CG, a switch 6, and a battery management system 100.

The cell group CG may be coupled to the inverter 3 through a pair of power terminals provided to the battery pack B. The cell group CG includes first to $N^{th}$ battery cells $BC_1$ to $BC_N$ connected in series. Here, N is a natural number of 2 or more and represents the number of battery cells. The $i^{th}$ battery cell $BC_i$ is not particularly limited by its type as long as it enables repeated charging and discharging, like a lithium-ion battery cell. i is an index for battery cell identification. i is a natural number from 1 to N.

The $i^{th}$ battery cell ($BC_i$) may be a battery bank including a plurality of unit cells connected in parallel. The unit cell may be a physically separate battery. The type of unit cell is not particularly limited as long as it can be repeatedly charged and discharged, such as a lithium-ion battery cell.

The switch 6 is connected in series to the cell group CG. The switch 6 is installed in the current path for charging and discharging the cell group CG. The switch 6 is controlled to turn on and off in response to a switching signal from the battery management system 100. The switch 6 may be a mechanical relay that turns on and off by the magnetic force of the coil, or a semiconductor switch such as a MOSFET (Metal Oxide Semiconductor Field Effect transistor).

The inverter 3 is provided to convert the direct current (DC) from the cell group CG to alternating current (AC) in response to a command from the battery management system 100 or the vehicle controller 5. The electric motor 4 may be, for example, a 3-phase AC motor. The electric motor 4 is driven using the AC power provided from the inverter 3.

The battery management system 100 is provided to take charge of overall control related to charging and discharging of the cell group CG while the vehicle 1 is operating. Here, the operation of the vehicle 1 may include running, temporary stop while running, parking, charging, or the like of the vehicle 1.

The battery management system 100 includes a battery diagnosis apparatus 200. The battery management system 100 may further include at least one of a current sensor 310, a temperature sensor 320, and an interface unit 330.

The battery diagnosis apparatus 200 is provided to diagnose voltage abnormalities in the first to $N^{th}$ battery cells $BC_1$ to $BC_N$ while the vehicle 1 is operating. The battery diagnosis apparatus 200 includes a voltage sensing circuit 210 and a control circuit 220.

The voltage sensing circuit 210 is connected to the positive electrode and negative electrode of each of the first to $N^{th}$ battery cells $BC_1$ to $BC_N$ through a plurality of voltage sensing lines. The voltage sensing circuit 210 is configured to measure the cell voltage across both ends of the $i^{th}$ battery cell ($BC_i$) at regular time intervals under the control of the control circuit 220 while the vehicle 1 is operating and generate a voltage signal indicating the measured cell voltage.

The voltage sensing circuit 210 may include a common voltage measuring circuit known in the art. The voltage measurement circuit may include a multiplexing circuit that may sequentially select battery cells subject to voltage measurement at time intervals, a filter circuit that removes noise from the voltage measurement signal, an amplifier circuit that amplifies the voltage measurement signal, or the like.

The current sensor 310 is connected in series to the cell group CG through a current path. The current sensor 310 is configured to detect the battery current flowing through the cell group CG at regular time intervals under the control of the control circuit 220 while the vehicle 1 is operating and generate a current signal indicating the detected battery current.

The current sensor 310 may be a common sensor known in the art, such as a sense resistor or a Hall sensor. The current flowing through the cell group CG may be a charging current or a discharging current.

The temperature sensor 320 is configured to detect the temperature of the cell group CG at regular time intervals under the control of the control circuit 220 while the vehicle 1 is operating and generate a temperature signal indicating the detected temperature.

The temperature sensor 320 may be a common sensor known in the art, such as a thermocouple. The temperature sensor 320 may be installed at multiple points within the battery pack B to independently measure the temperature of the $i^{th}$ battery cell ($BC_i$).

The control circuit 220 may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing the other functions.

The control circuit 220 may have a storage medium 221. The storage medium 221 may be, for example, at least one type of storage medium among flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM), and programmable read-only memory (PROM).

The storage medium 221 may store data and programs required for computation by the control circuit 220. The storage medium 221 may accumulatively store data indicating the result of computation, for example diagnosis result, by the control circuit 220 together with a time stamp.

The control circuit 220 may be operably coupled to the voltage sensing circuit 210, the temperature sensor 320, the current sensor 310, the interface unit 330, and/or the switch 6. The control circuit 220 may collect sensing signals from the voltage sensing circuit 210, the current sensor 310, and the temperature sensor 320 at regular time intervals while the vehicle 1 is operating. The sensing signals include voltage signal, current signal, and/or temperature signal. The voltage signal, current signal, and/or temperature signal may be measured using a synchronized method. The control circuit 220 may convert the voltage signal and/or current signal and/or temperature signal into digital data and accumulatively store them in the storage medium 221 together with a time stamp to generate time series data regarding the voltage and/or current and/or temperature of each $i^{th}$ battery cell ($BC_i$). Therefore, the time series data regarding the cell voltage of the $i^{th}$ battery cell ($BC_i$), the current flowing through the battery pack B, and the temperature of the battery pack B may be accumulatively stored in the storage medium 221.

The time series data for voltage may include a number of voltage data corresponding to the number of voltage measurements. One voltage data includes a measurement time and a measured voltage value. The time series data for current includes a number of current data corresponding to the number of current measurements. One current data includes a measurement time and a measured current value. The time series data for temperature includes a number of temperature data corresponding to the number of temperature measurements. One temperature data includes a measurement time and a measured temperature value.

The control circuit 220 may identify whether the $i^{th}$ battery cell ($BC_i$) is in charging, in discharging, or in a no-load state by referring to the magnitude and sign of the current measured through the current sensor 310.

Specifically, the control circuit 220 may identify that the battery cell is in a no-load state when the magnitude of the current measured through the current sensor 310 is 0 or is small to a minute current level. Also, the control circuit 220 may identify that the battery cell is in discharging when the magnitude of the current measured through the current sensor 310 is greater than 0 and the sign of the current value is positive. Also, the control circuit 220 may identify that the battery cell is in charging when the magnitude of the current measured through the current sensor 310 is greater than 0 and the sign of the current value is negative.

The interface unit 330 may include a communication circuit configured to support wired or wireless communication between the control circuit 220 and the vehicle controller 5 (for example, an Electronic Control Unit (ECU)). The wired communication may be, for example, controller area network (CAN) communication, and the wireless communication may be, for example, ZigBee or Bluetooth communication. The communication protocol is not limited to a particular type and may include any communication protocol capable of supporting wired/wireless communication between the control circuit 220 and the vehicle controller 5.

The interface unit 330 may be coupled with an output device 331 that provides information received from the vehicle controller 5 and/or the control circuit 220 in a form recognizable to the user. The output device 331 may include a display 331a and a speaker 331b.

The interface unit 330 may include a video I/O interface and/or an audio I/O interface to visually or audibly output the diagnosis result through the output device 331.

The vehicle controller 5 may control the inverter 3 based on battery information (e.g., voltage, current, temperature, SOC) collected through communication with the battery management system 100.

The control circuit 220 may record the time series data for the voltage of the $i^{th}$ battery cell ($BC_i$) measured by the voltage sensing circuit 210 in the storage medium 221 while the vehicle 1 is operating, and diagnose whether the battery cell exhibits a voltage abnormality using the corresponding time series data.

Specifically, the control circuit 220 periodically receives a voltage signal from the voltage sensing circuit 210 while the first to $N^{th}$ battery cells ($BC_1$ to $BC_N$) are being charged or discharged and records first to $N^{th}$ voltage time series data of the first to $N^{th}$ battery cells ($BC_1$ to $BC_N$) in the storage medium 221.

The control circuit 220 may initiate diagnosis of a voltage abnormality of the first to $N^{th}$ battery cells ($BC_1$ to $BC_N$) when the quantity of voltage data included in each of the first to $N^{th}$ voltage time series data reaches a preset number n. Here, n may range from hundreds to thousands, but the present disclosure is not limited thereto.

When diagnosis is initiated, the control circuit 220 selects a set of first voltages ($V_{i,k}$) measured at a first time ($t_k$) and a set of second voltages ($V_{i,k+1}$) measured at a second time ($t_{k+1}$) later than the first time ($t_k$) from the first to $N^{th}$ voltage time series data in the $k^{th}$ diagnosis cycle.

The first time ($t_k$) and the second time ($t_{k+1}$) indicate the time when the voltage is measured. Among the symbols representing the set of first voltages ($V_{i,k}$) and the set of second voltages ($V_{i,k+1}$), the subscript i is a natural number from 1 to N. Therefore, the set of first voltages ($V_{i,k}$) and the set of second voltages ($V_{i,k+1}$) include a total of N voltage values, respectively.

k is an index for the diagnosis cycle, and is a variable to distinguish each diagnosis cycle when the diagnosis cycle is repeated multiple times. Each of the first to $N^{th}$ voltage time series data includes a total of n voltage values as the voltage time series data of the first to $N^{th}$ battery cells. In one example, k has a value of 1 to n-1 and may increase by 1 from 1 to n-1 as the diagnosis cycle increases. That is, in the first diagnosis cycle, k is 1, and whenever the diagnosis cycle increases, k may increase sequentially from 2 to n-1. Since k varies from 1 to n-1, the number of progresses of the diagnosis cycles is n-1.

In an embodiment, the interval between the first time ($t_k$) and the second time ($t_{k+1}$) corresponds to the voltage measurement period. Alternatively, the interval between the first time ($t_k$) and the second time ($t_{k+1}$) may be an integer multiple of the voltage measurement period. In this case, since the time interval at which the set of first voltages ($V_{i,k}$) and the set of second voltages ($V_{i,k-1}$) are sampled from the first to $N^{th}$ voltage time series data increases, the number of diagnosis cycles is reduced compared to n-1. In one example, when the interval between the first time ($t_k$) and the second time ($t_{k+1}$) is m times of the voltage measurement period, the number of diagnosis cycles is reduced to 'n-1/m'. Value below the decimal point may be rounded down from the calculation result of a fractional expression related to the diagnosis cycle.

After selecting a set of first voltages ($V_{i,k}$) and a set of second voltages ($V_{i,k+1}$) from the first to $N^{th}$ voltage time series data, the control circuit 220 determines a coordinate <the first time ($t_k$), an average ($V_{k,ave}$) of the set of first voltages ($V_{i,k}$)> as a first average position vector and determines a coordinate <the second time ($t_{k+1}$), an average ($V_{k+1,ave}$) of the set of second voltages ($V_{i,k+1}$)> as a second average position vector.

In an embodiment, <the first time ($t_k$), the average ($V_{k,ave}$) of the set of first voltages ($V_{i,k}$)> and <the second time ($t_{k+1}$), the average ($V_{k+1,ave}$) of the set of second voltages ($V_{i,k+1}$)> correspond to two-dimensional vector coordinates.

Hereinafter, <the first time ($t_k$), the average ($V_{k,ave}$) of the set of first voltages ($V_{i,k}$)> is briefly expressed as <$t_k, V_{k,ave}$>, and <the second time ($t_{k+1}$), the average ($V_{k+1,ave}$) of the set of second voltages ($V_{i,k+1}$)> is briefly expressed as <$t_{k+1}, V_{k+1,ave}$>.

When the first average position vector and the second average position vector are expressed as $\vec{v}_{r,k}$ and $\vec{v}_{r,k}+1$, respectively, $\vec{v}_{r,k}$ and $\vec{v}_{r,k+1}$ may be expressed as in Formula 1 below.

Formula 1:

$$\vec{v}_{r,k} = <t_k, V_{k,ave}>$$

$$\vec{v}_{r,k+1} = <t_{k+1}, V_{k+1,ave}>$$

In one aspect, the average $V_{k,ave}$ of the set of first voltages ($V_{i,k}$) may be an arithmetic average value of the set of first voltages ($V_{i,k}$). Similarly, the average $V_{k+1,ave}$ of the set of second voltages ($V_{i,k+1}$) may be an arithmetic average value of the set of second voltages ($V_{i,k+1}$).

In another aspect, the average $V_{k,ave}$ of the set of first voltages ($V_{i,k}$) may be a median value of the set of first voltages ($V_{i,k}$). Similarly, the average $V_{k+1,ave}$ of the set of second voltages ($V_{i,k+1}$) may be a median value of the set of second voltages ($V_{i,k+1}$).

In still another aspect, the average $V_{k,ave}$ of the set of first voltages ($V_{i,k}$) may be an arithmetic average value or a median value of the voltage values within $\beta$ sigma among the voltage values included in the set of first voltages ($V_{i,k}$).

Similarly, the average $V_{k+1,ave}$ of the set of second voltages ($V_{i,k+1}$) may be an arithmetic average value or a median value of the voltage values within $\beta$ sigma among the voltage values included in the set of second voltages ($V_{i,k+1}$). $\beta$ is 1 to 3, and sigma is the standard deviation of the voltage values included in the voltage set.

After determining the first average position vector $\vec{v}_{r,k}$ and the second average position vector $\vec{v}_{r,k+1}$, the control circuit 220 may determine the difference between the first average position vector $\vec{v}_{r,k}$ and the second average position vector $\vec{v}_{r,k+1}$ as a diagnosis reference vector $\vec{v}_{refer,\ k}$.

The diagnosis reference vector $\vec{v}_{refer,k}$ may be expressed as in Formula 2 below.

Formula 2:

$$\vec{v}_{refer,k} = \vec{v}_{r,k+1} - \vec{v}_{r,k} = <t_{k+1} - t_k, V_{k+1,ave} - V_{k,ave}>$$

Separately from determining the diagnosis reference vector $\vec{v}_{refer,k}$, the control circuit 220 determines the diagnosis vector $\vec{v}_{refer,k}$ for the $i^{th}$ battery cell ($BC_i$, i is 1 to N). Since i is 1 to N, the number of diagnosis vectors $\vec{v}$ is N.

The method for determining the diagnosis vector $\vec{v}$ is similar to the method for determining the diagnosis reference vector $\vec{v}$. That is, the control circuit 220 determines $<t_k, V_{i,k}>$ corresponding to $<$the first time, the first voltage$>$ for the $i^{th}$ battery cell ($BC_i$, i is 1 to N) as the first diagnosis position vector $\vec{v}_{fer,ki,k}$ and determines $<t_{k+1}, V_{i,k+1}>$ corresponding to $<$the second time, the second voltage$>$ as the second diagnosis position vector $\vec{v}_{i,k+1}$. Also, the difference between the second diagnosis position vector $\vec{v}_{i,k+1}$ and the first diagnosis position vector $\vec{v}_{i,k}$ is determined as the $i^{th}$ diagnosis vector $\vec{v}_{diag\_i,k}$. The $i^{th}$ diagnosis vector $\vec{v}_{diag\_i,k}$ of the $i^{th}$ battery cell ($BC_i$) may be expressed as in Formula 3 below.

Formula 3:

$$\vec{v}_{i,k} = <t_k, V_{i,k}>$$

$$\vec{v}_{i,k+1} = <t_{k+1}, V_{i,k+1}>$$

$$\vec{v}_{diag\_i,k} = \vec{v}_{i,k+1} - \vec{v}_{i,k} = <t_{k+1} - t_k, V_{i,k+1} - V_{i,k}>$$

The control circuit 220 determines the $i^{th}$ diagnosis factor based on a magnitude of a cross product $\vec{v}_{refer,\ k} \times \vec{v}_{diag\_i,k}$ of the diagnosis reference vector $\vec{v}_{refer,k}$ and the $i^{th}$ diagnosis vector $\vec{v}_{diag\_i,k}$ to diagnose a voltage abnormality of the $i^{th}$ battery cell ($BC_i$).

The cross product $\vec{v}_{refer,\ k} \times \vec{v}_{diag\_i,k}$ may be simply calculated using a matrix as shown in Formula 4 below.

**Formula 4:**

$$\vec{v}_{\text{refer,k}} \times \vec{v}_{\text{diag\_i,k}} = \begin{bmatrix} i & j & k \\ t_{k+1}\text{-}t_k & V_{k+1,\text{ave}}\text{-}V_{k,\text{ave}} & 0 \\ t_{k+1}\text{-}t_k & V_{i,k+1}\text{-}V_{i,k} & 0 \end{bmatrix}$$

$$= i \begin{vmatrix} V_{k+1,\text{ave}}\text{-}V_{k,\text{ave}} & 0 \\ V_{i,k+1}\text{-}V_{i,k} & 0 \end{vmatrix} - j \begin{vmatrix} t_{k+1}\text{-}t_k & 0 \\ t_{k+1}\text{-}t_k & 0 \end{vmatrix} + k \begin{vmatrix} t_{k+1}\text{-}t_k & V_{k+1,\text{ave}}\text{-}V_{k,\text{ave}} \\ t_{k+1}\text{-}t_k & V_{i,k+1}\text{-}V_{i,k} \end{vmatrix}$$

$$= k\{(t_{k+1}\text{-}t_k)(V_{i,k+1}\text{-}V_{i,k}) - (V_{k+1,\text{ave}}\text{-}V_{k,\text{ave}})(t_{k+1}\text{-}t_k)\}$$

$$= k(t_{k+1}\text{-}t_k)\{(V_{i,k+1}\text{-}V_{i,k}) - (V_{k+1,\text{ave}}\text{-}V_{k,\text{ave}})\}$$

In Formula 4, i, j, and k are unit vectors of a three-dimensional coordinate system, respectively, and may be expressed as coordinates <1,0,0>, <0,1,0>, and <0,0,1>.

Also, the magnitude of the cross product $\vec{v}_{\text{refer,k}} \times \vec{v}_{\text{diag\_i,k}}$ may be expressed as shown in Formula 5 below.

**Formula 5:**

$$\left| \vec{v}_{refer,k} \times \vec{v}_{diag\_i,k} \right| = |t_{k+1} - t_k| \left| (V_{i,k+1}\text{-}V_{i,k}) - (V_{k+1,\text{ave}}\text{-}V_{k,\text{ave}}) \right|$$

In Formula 5, $|t_{k+1} - t_k|$ may be considered as a constant. Therefore, the ith diagnosis factor for the ith battery cell (BC_i) may be substantially expressed as a function depending on $V_{i,k+1}$, $V_{i,k}$, $V_{k+1,\text{ave}}$ and $V_{k,\text{ave}}$.

When expressing the ith diagnosis factor as a function $J_{i,k}$, the ith diagnosis factor $J_{i,k}$ may be approximately expressed as in Formula 6.

**Formula 6:**

$$J_{i,k}(V_{k,\text{ave}}, V_{k+1,\text{ave}}, V_{i,k}, V_{i,k+1}) = \left| (V_{i,k+1}\text{-}V_{i,k}) - (V_{k+1,\text{ave}}\text{-}V_{k,\text{ave}}) \right|$$

Meanwhile, according to vector theory, a magnitude of a cross product of two vectors corresponds to the area of the equilibrium quadrilateral formed by the two vectors. In other words, a magnitude of the cross product $\vec{v}_{\text{refer, k}} \times \vec{v}_{\text{diag\_i,k}}$ may be expressed as in Formula 7 below.

**Formula 7:**

$$\vec{v}_{\text{refer,k}} \times \vec{v}_{\text{diag\_i,k}} = \left| \vec{v}_{refer,k} \right| \left| \vec{v}_{diag\_i,k} \right| Sin\theta$$

In Formula 7, θ corresponds to an angle between two vectors. According to the characteristics of the sine function, as the angle between two vectors is smaller, the magnitude of the cross product is closer to 0. For reference, when θ increases from 0 degrees to 90 degrees, Sinθ increases from 0 to 1, and when θ increases from 90 degrees to 180 degrees, Sinθ decreases again from 1 to 0.

Therefore, the ith diagnosis factor $J_{i,k}$ for the ith battery cell (BC_i) may be used as an index that quantitatively indicates the degree of parallelism between the diagnosis reference vector $\vec{v}_{refer,k}$ and the ith diagnosis vector $\vec{v}_{diag\_i,k}$ for the ith battery cell (BC_i). In other words, as the ith diagnosis factor $J_{i,k}$ is smaller, the angle between the diagnosis reference vector $\vec{v}_{refer,k}$ and the ith diagnosis vector $\vec{v}_{diag\_i,k}$ is closer to 0 degrees, so the degree of parallelism between the two vectors may be considered greater.

If the ith battery cell (BC_i) does not exhibit a voltage abnormality, the angle between the ith diagnosis vector $\vec{v}_{diag\_i,k}$ and the diagnosis reference vector $\vec{v}_{refer,k}$ is very small, so the ith diagnosis factor $J_{i,k}$ has a small value close to 0. It is because, if the ith battery cell (BC_i) is normal, it will show similar voltage behavior to other battery cells. Conversely, if the ith battery cell (BC_i) exhibiting a voltage abnormality shows abnormal voltage change behavior unlike other battery cells, the angle between the ith diagnosis vector $\vec{v}_{diag\_i,k}$ and the diagnosis reference vector $\vec{v}_{refer,k}$ increases, so the ith diagnosis

EP 4 553 515 B1

factor $J_{i,k}$ may increase to a value that cannot be ignored.

The control circuit 220 may diagnose a voltage abnormality of the $i^{th}$ battery cell ($BC_i$) using the characteristics of the $i^{th}$ diagnosis factor $J_{i,k}$ as above. In other words, the control circuit 220 may diagnose that the $i^{th}$ battery cell ($BC_i$) exhibits a voltage abnormality if the $i^{th}$ diagnosis factor $J_{i,k}$ exceeds the threshold value.

The control circuit 220 may set the threshold value based on the average of the $i^{th}$ diagnosis factors $J_{i,k}$ (i is 1 to N).

In one example, when the average of $i^{th}$ diagnosis factors $J_{i,k}$ is defined as $m_{ave}$, the control circuit 220 may set a value corresponding to $m_{ave}*\alpha$ as the threshold value. Here, the average may be an arithmetic average value or a median value for diagnosis factors, or an average value or a median value for diagnosis factors that fall within $\beta$ sigma among the diagnosis factors. $\alpha$ may be 1 to 10, preferably 3 to 4. However, the present disclosure is not limited by the specific number assigned to $\alpha$.

Alternatively, the threshold value may be a value preset through repeated experiments (trial & error). In other words, the diagnosis factor for the battery cell that actually exhibits a voltage abnormality may be determined through an experiment, and the threshold value may be set to a value that is several percent to tens of percent lower than the diagnosis factor confirmed in the experiment. In this case, the threshold value may be recorded in advance in the storage medium 221, and the control circuit 220 may refer to the threshold value recorded in the storage medium 221.

If the $i^{th}$ battery cell ($BC_i$) is diagnosed as exhibiting a voltage abnormality, the control circuit 220 may record the diagnosis result in the storage medium 221. The diagnosis result may include the time point at which the voltage abnormality of the $i^{th}$ battery cell ($BC_i$) is diagnosed and identification information (serial number, etc.) of the battery cell exhibiting the voltage abnormality. If a plurality of battery cells are diagnosed as exhibiting a voltage abnormality, the diagnosis result may include the diagnosis time point and the identification information for each battery cell exhibiting a voltage abnormality.

The control circuit 220 may also output the diagnosis result visually or audibly through the output device 331 operably coupled with the interface unit 330.

In one example, the control circuit 220 may output the diagnosis result to a graphical user interface through the display 331a. In another example, the control circuit 220 may output the diagnosis result as a voice through the speaker 331b. Preferably, the diagnosis result may include a warning message that the battery pack B requires detailed inspection. When the diagnosis result is output visually or audibly, it is also possible to output only a warning message, excluding the time point at which the voltage abnormality is diagnosed and the identification information of the battery cell.

The control circuit 220 may also transmit the diagnosis result to an external device through wired or wireless communication supported by the interface unit 330.

In one example, the external device may be a vehicle controller 5. When the vehicle controller 5 receives the diagnosis result, a warning message may be output in a graphical user interface through an integrated display panel mounted on the vehicle 1. In this case, a driver may bring the vehicle 1 to a service center and conduct a thorough inspection on the battery pack B. If a battery cell exhibiting a voltage abnormality is found through the thorough inspection, the battery cell may be replaced with another battery cell, or the battery pack B may be replaced.

In another example, the external device may be an on-board diagnosing device (not shown) connected through the interface unit 330. The on-board diagnosing device is a device that checks the status of various parts included in the vehicle 1. When the on-board diagnosing device is connected through the interface unit 330, the control circuit 220 may read the diagnosis result regarding the voltage abnormality of the battery cell stored in the storage medium 221 and transmit it to the on-board diagnosing device through the interface unit 330. Then, an operator may recognize the diagnosis result output through the display of the on-board diagnosing device and perform a thorough inspection on the battery pack B. Also, if a battery cell exhibiting a voltage abnormality is found, the operator may replace the corresponding battery cell with another battery cell, or the battery pack B may be replaced.

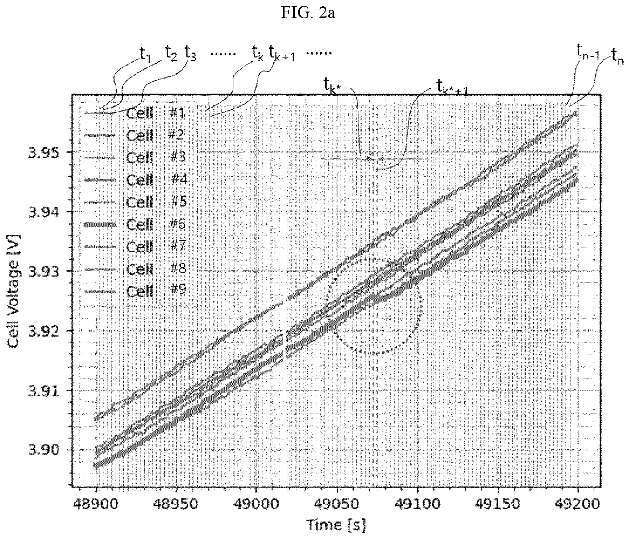

FIG. 2a is a graph showing 9 voltage time series data for a total of 9 battery cells according to an embodiment of the present disclosure. In the drawing, vertical dotted lines indicate a plurality of voltage measurement time points.

As shown in FIG. 2a, among a total of 9 battery cells, the battery cell with ID number 6 exhibits abnormal voltage change behavior (see dotted circle) in the time section between 49070 seconds and 49080 seconds of the voltage time series data (ID#6) since lithium plating occurs at the negative electrode, unlike other battery cells. In other words, other battery cells except the battery cell #6 show a pattern in which the voltage increases linearly, but the battery cell #6 shows the characteristic that the slope of the voltage sudden changes in the time section of 49070 to 49080 seconds. For reference, the voltages of the 9 battery cells are slightly different at the same measurement time point because the degrees of deterioration of the battery cells are different from each other.

The battery diagnosis apparatus 200 according to an embodiment of the present disclosure may diagnose that the battery cell #6 exhibits a voltage abnormality after the voltage time series data as shown in FIG. 2a are stored in the storage medium 221.

Specifically, the control circuit 220 may determine the $i^{th}$ diagnosis factor $J_{i,1}$ of the $i^{th}$ battery cell ($BC_i$) using the diagnosis reference vector $\vec{v}_{refer,1}$ determined from the set of first voltages ($V_{i,1}$, i is 1 to 9) and the set of second voltages ($V_{i,2}$, i is 1 to 9) measured at the first time ($t_1$) and the second time ($t_2$) in the first diagnosis cycle and the $i^{th}$ diagnosis vector

$\vec{v}_{diag\_i,1}$ of the i$^{th}$ battery cell (BC$_i$), and diagnose whether the i$^{th}$ battery cell (BC$_i$) exhibits a voltage abnormality depending on whether the i$^{th}$ diagnosis factor $J_{i,1}$ exceeds the threshold value. Since i is 1 to 9, voltage abnormality diagnosis is made independently for each of a total of 9 battery cells in the first diagnosis cycle.

Similarly, the control circuit 220 may determine the i$^{th}$ diagnosis factor $J_{i,2}$ of the i$^{th}$ battery cell (BC$_i$) using the diagnosis reference vector $\vec{v}_{refer,2}$ determined from the set of first voltages (V$_{i,2}$, i is 1 to 9) and the set of second voltages (V$_{i,3}$, i is is 1 to 9) measured at the first time (t$_2$) and the second time (t$_3$) in the second diagnosis cycle and the i$^{th}$ diagnosis vector $\vec{v}_{diag\_i,2}$ of the i$^{th}$ battery cell (BC$_i$), and diagnose whether the i$^{th}$ battery cell (BC$_i$) exhibits a voltage abnormality depending on whether the i$^{th}$ diagnosis factor $J_{i,2}$ exceeds the threshold value. Since i is 1 to 9, even in the second diagnosis cycle, voltage abnormality diagnosis is made independently for each of a total of 9 battery cells.

Similarly, the control circuit 220 may determine the i$^{th}$ diagnosis factor $J_{i,k}$ of the i$^{th}$ battery cell (BC$_i$) using the diagnosis reference vector $\vec{v}_{refer,k}$ determined from the set of first voltages (V$_{i,k}$, i is 1 to 9) and the set of second voltages (V$_{i,k+1}$, i is is 1 to 9) measured at the first time (t$_k$) and the second time (t$_{k+1}$) in any k$^{th}$ diagnosis cycle and the i$^{th}$ diagnosis vector $\vec{v}_{diag\_i,k}$ of the i$^{th}$ battery cell (BC$_i$), and diagnose whether the i$^{th}$ battery cell (BC$_i$) exhibits a voltage abnormality depending on whether the i$^{th}$ diagnosis factor $J_{i,k}$ exceeds the threshold value. Since i is 1 to 9, even in the k$^{th}$ diagnosis cycle, voltage abnormality diagnosis is made independently for each of a total of 9 battery cells.

Finally, the control circuit 220 may determine the i$^{th}$ diagnosis factor $J_{i,n-1}$ of the i$^{th}$ battery cell (BC$_i$) using the diagnosis reference vector $\vec{v}_{refer,n-1}$ determined from the set of first voltages (V$_{i,n-1}$, i is 1 to 9) and the set of second voltages (V$_{i,n}$, i is is 1 to 9) measured at the first time (t$_{n-1}$) and the second time (t$_n$) in the n-1$^{th}$ diagnosis cycle and the i$^{th}$ diagnosis vector $\vec{v}_{diag\_i,n-1}$ of the i$^{th}$ battery cell (BC$_i$), and diagnose whether the i$^{th}$ battery cell (BC$_i$) exhibits a voltage abnormality depending on whether the i$^{th}$ diagnosis factor $J_{i,n-1}$ exceeds the threshold value. Since i is 1 to 9, even in the n-1$^{th}$ diagnosis cycle, voltage abnormality diagnosis is made independently for each of a total of 9 battery cells.

Meanwhile, the battery cell #6 shows an abnormal voltage change behavior in which the slope of the voltage change switches from positive to negative while the voltage suddenly decreases in the first time (t$_{k*}$) and second time (t$_{k*+1}$) sections among the plurality of voltage measurement time points. Therefore, the diagnosis factor $J_{6,k*}$ of the battery cell #6 determined from the voltage set selected at the first time (t$_{k*}$) and the second time (t$_{k*+1}$) may be greater than the diagnosis factors of other battery cells, namely $J_{1,k*}$, $J_{2,k*}$, $J_{3,k*}$, $J_{4,k*}$, $J_{5,k*}$, $J_{7,k*}$, $J_{8,k*}$, $J_{9,k*}$.

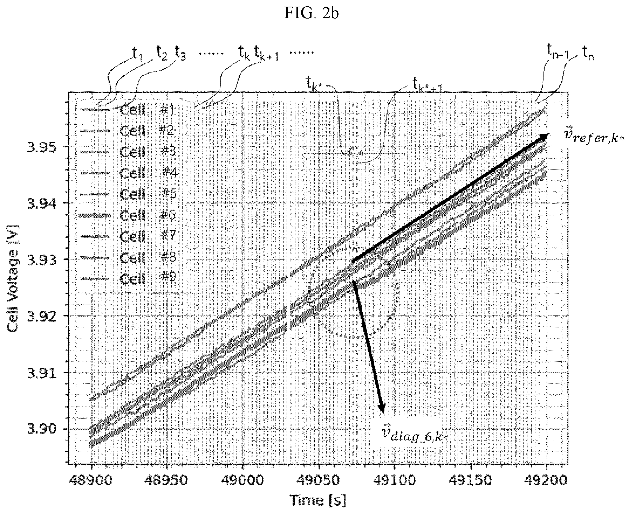

FIG. 2b is a drawing showing a diagnosis reference vector $\vec{v}_{refer,k*}$ determined from a voltage set at a first time (t$_{k*}$) and a second time (t$_{k*+1}$) according to an embodiment of the present disclosure and a diagnosis vector $\vec{v}_{diag\_6,k*}$ for a battery cell #6, together with the graph of FIG. 2a.

As shown in the drawing, the angle between the diagnosis reference vector $\vec{v}_{refer,k*}$ and the diagnosis vector $\vec{v}_{diag\_6,k*}$ of the battery cell #6 is quite large, approximately close to 90 degrees. In other words, the degree of parallelism between the diagnosis reference vector $\vec{v}_{refer,k*}$ and the diagnosis vector $\vec{v}_{diag\_6,k}*$ of the battery cell #6 is quite low. Therefore, it is obvious that the diagnosis factor $J_{6,k*}$ of the battery cell #6 will have a significantly larger value compared to the diagnosis factors of other battery cells.

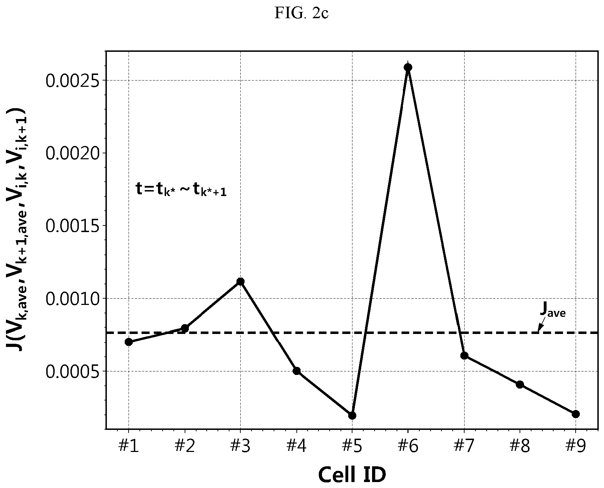

FIG. 2c is a graph showing diagnosis factors $J_{1,k*}$, $J_{2,k*}$, $J_{3,k*}$, $J_{4,k*}$, $J_{5,k*}$, $J_{6,k*}$, $J_{7,k*}$, $J_{8,k*}$ and $J_{9,k*}$ determined from a voltage set at the first time (t$_{k*}$) and the second time (t$_{k*+1}$) when the battery cell #6 exhibits a voltage abnormality.

Referring to FIG. 2c, the average $J_{ave}$ of the diagnosis factors is approximately 0.00078 based on the arithmetic average value. The diagnosis factors of the battery cells #1 to #5 and the battery cells #7 to #9 do not show much deviation compared to the average, but the diagnosis factor of the battery cell #6 has a value that is more than 3 times greater than the average. Therefore, if the threshold value used as a standard for diagnosing a voltage abnormality of the battery cell is set to twice of the average of the diagnosis factor, the battery cell #6 may be diagnosed as exhibiting a voltage abnormality at a time section between the first time (t$_{k*}$) and second time (t$_{k*+1}$). In this case, the control circuit 220 may record the time t$_{k*}$ at which the battery cell #6 is diagnosed as exhibiting a voltage abnormality and the identification information of the battery cell (ID #6) as a diagnosis result in the storage medium 221. Also, the control circuit 220 may output the diagnosis result including a warning message visually or audibly through the output device 331 operably coupled with the interface unit 330. Also, the control circuit 220 may transmit the diagnosis result to an external device through the interface unit 330.

The control circuit 220 may periodically execute the diagnosis logic for detecting the voltage abnormality of the battery cell described above for all battery cells included in the battery pack B. Also, the control circuit 220 may independently execute the diagnosis logic for each battery cell according to a predetermined order when executing diagnosis logics for all battery cells.

The control circuit 220 may also execute in real time the diagnosis logic for detecting the voltage abnormality of the battery cell described above in association with the measurement of cell voltage before obtaining the time series data for the n number of preset battery cell voltages.

Specifically, the control circuit 220 may determine the diagnosis reference vector $\vec{v}_{refer,1}$ and the i$^{th}$ diagnosis vector $\vec{v}_{diag\_i,1}$ of the i$^{th}$ battery cell (BC$_i$) using the set of first voltages (V$_{i,1}$) measured at the first time (t$_1$) and the set of second voltages (V$_{i,2}$) measured at the second time (t$_2$) immediately after the first voltage measurement time point (t$_1$) and the second voltage measurement time point (t$_2$) have elapsed, determine the i$^{th}$ diagnosis factor $J_{i,1}$ of the i$^{th}$ battery cell (BC$_i$) using the diagnosis reference vector $\vec{v}_{refer,1}$ and the i$^{th}$ diagnosis vector $\vec{v}_{diag\_i,1}$ of the i$^{th}$ battery cell (BC$_i$), and

diagnose whether the $i^{th}$ battery cell ($BC_i$) exhibits a voltage abnormality depending on whether the $i^{th}$ diagnosis factor $J_{i,1}$ exceeds the threshold value.

Similarly, the control circuit 220 may determine the diagnosis reference vector $\vec{v}_{refer,2}$ and the $i^{th}$ diagnosis vector $\vec{v}_{diag\_i,2}$ of the $i^{th}$ battery cell ($BC_i$) using the set of first voltages ($V_{i,2}$) measured at the first time ($t_2$) and the set of second voltages ($V_{i,3}$) measured at the second time ($t_3$) immediately after the second voltage measurement time point ($t_2$) and the third voltage measurement time point ($t_3$) have elapsed, determine the $i^{th}$ diagnosis factor $J_{i,2}$ of the $i^{th}$ battery cell ($BC_i$) using the diagnosis reference vector $\vec{v}_{refer,2}$ and the $i^{th}$ diagnosis vector $\vec{v}_{diag\_i,2}$ of the $i^{th}$ battery cell ($BC_i$), and diagnose whether the $i^{th}$ battery cell exhibits a voltage abnormality depending on whether the $i^{th}$ diagnosis factor $J_{i,2}$ exceeds the threshold value.

Similarly, the control circuit 220 may determine the diagnosis reference vector $\vec{v}_{refer,k}$ and the $i^{th}$ diagnosis vector $\vec{v}_{diag\_i,k}$ of the $i^{th}$ battery cell ($BC_i$) using the set of first voltages ($V_{i,k}$) measured at the first time ($t_k$) and the set of second voltages ($V_{i,k+1}$) measured at the second time ($t_{k+1}$) immediately after any $k^{th}$ voltage measurement time point ($t_k$) and $k+1^{th}$ voltage measurement time point ($t_{k+1}$) have elapsed, determine the $i^{th}$ diagnosis factor $J_{i,k}$ of the $i^{th}$ battery cell ($BC_i$) using the diagnosis reference vector $\vec{v}_{refer,k}$ and the $i^{th}$ diagnosis vector $\vec{v}_{diag\_i,k}$ of the $i^{th}$ battery cell ($BC_i$), and diagnose whether the $i^{th}$ battery cell ($BC_i$) exhibits a voltage abnormality depending on whether the $i^{th}$ diagnosis factor $J_{i,k}$ exceeds the threshold value.

Finally, the control circuit 220 may determine the diagnosis reference vector $\vec{v}_{refer,n-1}$ and the $i^{th}$ diagnosis vector $\vec{v}_{diag\_i,n-1}$ of the $i^{th}$ battery cell ($BC_i$) using the set of first voltages ($V_{i,n-1}$) measured at the first time ($t_{n-1}$) and the set of second voltages ($V_{i,n}$) measured at the second time ($t_n$) immediately after the n-1$^{th}$ voltage measurement time point ($t_{n-1}$) and the $n^{th}$ voltage measurement time point ($t_n$) have elapsed, determine the $i^{th}$ diagnosis factor $J_{i,n-1}$ of the $i^{th}$ battery cell ($BC_i$) using the diagnosis reference vector $\vec{v}_{refer,n-1}$ and the $i^{th}$ diagnosis vector $\vec{v}_{diag\_i,n-1}$ of the $i^{th}$ battery cell ($BC_i$), and diagnose whether the $i^{th}$ battery cell ($BC_i$) exhibits a voltage abnormality depending on whether the $i^{th}$ diagnosis factor $J_{i,n-1}$ exceeds the threshold value.

The battery diagnosis apparatus 200 according to an embodiment of the present disclosure may be included in a battery management system 100, a control system of a load device (not shown), or a diagnostic system or the like provided in a maintenance center of the vehicle 1 or the battery pack B.

In the present disclosure, the control circuit 220 may optionally include a processor, an application-specific integrated circuit (ASIC), other chipsets, logic circuits, registers, communication modems, data processing devices, etc. known in the art to execute the various control logics described above.

Also, when the control logics are implemented as software, the control circuit 220 may be replaced with a processor that executes a set of program modules. At this time, the program module may be stored in a memory and executed by the processor. The memory may be provided inside or outside the processor, and may be connected to the processor by various well-known computer components. Also, the memory may be included in the storage medium 221. Also, the memory generically refers to a device that stores information regardless of the type of device, and does not refer to a specific memory device.

In addition, one or more of the various control logics of the control circuit 220 are combined, and the combined control logics may be written in a computer-readable code system and recorded on a computer-readable recording medium. The type of the recording medium is not particularly limited as long as it can be accessed by a processor included in a computer. As an example, the recording medium includes at least one selected from the group including a ROM, a RAM, a register, a CD-ROM, a magnetic tape, a hard disk, a floppy disk, and an optical data recording device. In addition, the code system may be distributed and stored and executed in computers connected through a network. In addition, functional programs, codes and code segments for implementing the combined control logics may be easily inferred by programmers in the art to which the present disclosure belongs.

Hereinafter, a battery diagnosis method using the battery diagnosis apparatus 200 of the present disclosure described above will be described in detail. In one embodiment, the battery diagnosis method may be performed by the battery diagnosis apparatus 200 while the vehicle 1 is operating. The operation of the vehicle 1 may include running, temporary stop while running, parking, charging, or the like of the vehicle 1. The operation of the control circuit 220 will be described in more detail in various embodiment(s) of the battery diagnosis method.

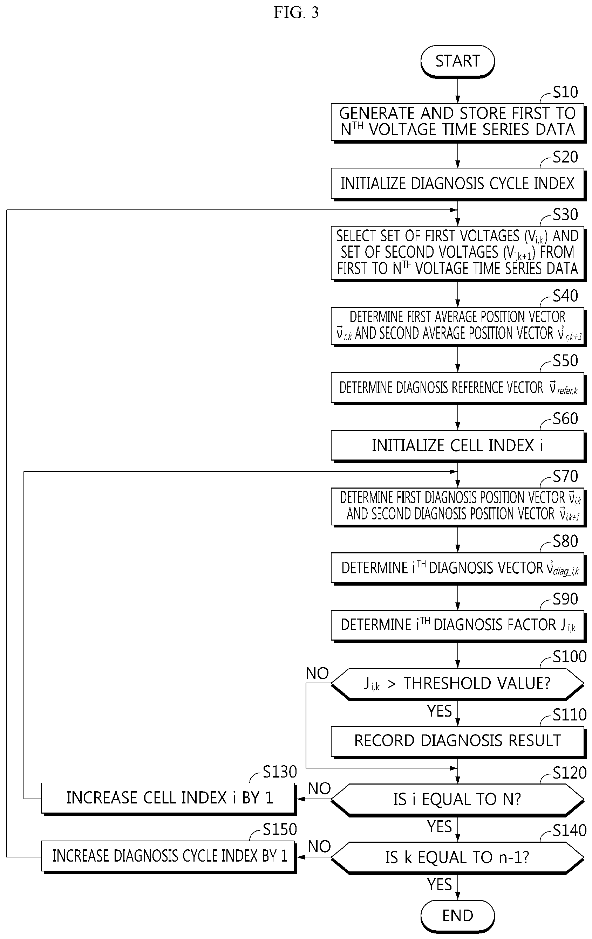

FIG. 3 is a flowchart for exemplarily illustrating a battery diagnosis method according to an embodiment of the present disclosure. The diagnosis method of FIG. 3 may be repeatedly executed for each battery cell included in the battery pack B at each diagnosis cycle preset by the control circuit 220.

Referring to FIG. 3, in the step S10, when the diagnosis starts, the control circuit 220 controls the voltage sensing circuit 210 to repeatedly measure the voltage of the first to $N^{th}$ battery cells ($BC_1$ to $BC_N$) at regular time intervals ($\Delta t$) so as to generate first to $N^{th}$ voltage time series data and record the same in the storage medium 221. The $i^{th}$ voltage time series data corresponds to voltage time series data for the $i^{th}$ battery cell ($BC_i$).

Subsequently, in the step S20, the control circuit 220 initializes the index k by assigning 1 to the index k for the diagnosis cycle.

Subsequently, in the step S30, the control circuit 220 selects a set of first voltages ($V_{i,k}$) measured at the first time

$(t_k)$ and a set of second voltages $(V_{i,k+1})$ measured at the second time $(t_{k+1})$ later than the first time $(t_k)$ from the first to N$^{th}$ voltage time series data recorded in the storage medium 221. i is 1 to N. Therefore, the number of voltage values included in the set of first voltages $(V_{i,k})$ is N. Likewise, the number of voltage values included in the set of second voltages $(V_{i,k+1})$ is also N. The currently assigned value of k is 1.

Subsequently, in the step S40, the control circuit 220 determines the coordinate $<t_k, V_{k,ave}>$ as a first average position vector $\vec{v}_{r,k}$ and the coordinate $<t_{k+1}, V_{k+1,ave}>$ as a second average position vector $\vec{v}_{r,k+1}$.

Various embodiments for the average $V_{k,ave}$ of the set of first voltages $(V_{i,k})$ and the average $V_{k+1,ave}$ of the set of second voltages $(V_{i,k+1})$ are described above.

Subsequently, in the step S50, the control circuit 220 determines a difference between the first average position vector $\vec{v}_{r,k}$ and the second average position vector $\vec{v}_{refer,1}$ as a diagnosis reference vector $\vec{v}_{refer,k}$.

Subsequently, in the step S60, the control circuit 220 initializes the cell index by assigning 1 to the cell index i.

Subsequently, in the step S70, the control circuit 220 determines the coordinate $<t_k, V_{i,k}>$ as the first diagnosis position vector $\vec{v}_{i,k}$ for the i$^{th}$ battery cell $(BC_i)$ and determines the coordinate $<t_{k+1}, V_{i,k+1}>$ as the second diagnosis position vector $\vec{v}_{i,k+1}$ for the i$^{th}$ battery cell $(BC_i)$.

Subsequently, in the step S80, the control circuit 220 determines the difference between the first diagnosis position vector $\vec{v}_{v,k}$ and the second diagnosis position vector $\vec{v}_{i,k+1}$ as the i$^{th}$ diagnosis vector $\vec{v}_{diag\_i,k}$ of the i$^{th}$ battery cell $(BC_i)$.

Subsequently, in the step S90, the control circuit 220 determines the i$^{th}$ diagnosis factor $J_{i,k}$ based on a magnitude of the cross product of the diagnosis reference vector $\vec{v}_{refer,k}$ and the i$^{th}$ diagnosis vector $\vec{v}_{diag\_i,k}$ using Formulas 4 to 6.

Subsequently, in the step S100, the control circuit 220 determines whether the i$^{th}$ diagnosis factor $J_{i,k}$ exceeds the threshold value. Various embodiments for setting the threshold value have already been described in detail.

If the determination of the step S100 is YES, in the step S110, the control circuit 220 records the diagnosis result in the storage medium 221. The diagnosis result includes the time $(t_k)$ at which the battery cell is diagnosed as exhibiting a voltage abnormality and identification information of the battery cell. The identification information is ID of the battery cell and may be a cell index.

If the determination of step S100 is NO, in the step S120, the control circuit 220 determines whether the cell index i is equal to N, which is the number of total battery cells.

If the determination of the step S120 is NO, in the step S130, the control circuit 220 increases the cell index i by 1 and then returns the process to the step S70 and repeats the steps S70 to S110 again to diagnose whether a battery cell subject to the next diagnosis exhibits a voltage abnormality. Since the cell index i is assigned with 2, the control circuit 220 diagnoses whether the second battery cell $(BC_2)$ exhibits a voltage abnormality. The steps S70 to S110 are repeatedly executed until the determination of the step S120 is YES. In other words, the steps S70 to S110 may be repeated until the voltage abnormality diagnosis for the N$^{th}$ battery cell $(BC_N)$ is completed.

If the determination of the step S120 is YES, in the step S140, the control circuit 220 determines whether the diagnosis cycle index k is equal to n-1. Here, n is the number of voltage values included in each of the first to N$^{th}$ voltage time series data. Since 1 is currently assigned to k, in the step S150, the control circuit 220 increases the diagnosis cycle index by 1 and then returns the process to the step S30 to proceed with the second diagnosis cycle.

That is, the control circuit 220 determines the coordinate $<t_2, V_{2,ave}>$ as the first average position vector $\vec{v}_{r,2}$, determines the coordinate $<t_3, V_{3,ave}>$ as the second average position vector $\vec{v}_{r,3}$, and determines the difference between the first average position vector $\vec{v}_{r,2}$ and the second average position vector $\vec{v}_{r,3}$ as the diagnosis reference vector $\vec{v}_{refer,2}$.

Subsequently, the control circuit 220 initializes the cell index by assigning 1 to the cell index i, determines the coordinate $<t_2, V_{i,2}>$ as the first diagnosis position vector $\vec{v}_{i,2}$ for the i$^{th}$ battery cell $(BC_i)$, determines the coordinate $<t_3, V_{i,3}>$ as the second diagnosis position vector $\vec{v}_{i,3}$ for the i$^{th}$ battery cell $(BC_i)$, determines the difference between the first diagnosis position vector $\vec{v}_{i,2}$ and the second diagnosis position vector $\vec{v}_{i,3}$ as the i$^{th}$ diagnosis vector $\vec{v}_{diag\_i,2}$ of the i$^{th}$ battery cell $(BC_i)$, and determines the i$^{th}$ diagnosis factor $J_{i,2}$ based on a magnitude of the cross product of the diagnosis reference vector $\vec{v}_{refer,2}$ and the i$^{th}$ diagnosis vector $\vec{v}_{diag\_i,2}$, and diagnoses whether the i$^{th}$ battery cell $(BC_i)$ exhibits a voltage abnormality depending on whether the i$^{th}$ diagnosis factor $J_{i,2}$ exceeds the threshold value. Also, the control circuit 220 may repeatedly perform the above procedures until the cell index i becomes equal to N.

If the second diagnosis cycle is completed, the control circuit 220 increases the diagnosis cycle index k again by 1 and then proceeds with the third diagnosis cycle.

The control circuit 220 executes the control logic described above in substantially the same way from the third diagnosis cycle to the n-1$^{th}$ diagnosis cycle to diagnose whether the first to N$^{th}$ battery cells $(BC_1$ to $BC_N)$ exhibit a voltage abnormality using the set of first voltages $(V_{i,k})$ and the set of second voltages $(V_{i,k+1})$ selected at the first time $(t_k)$ and the second time $(t_{k+1})$ later than the first time $(t_k)$.

Meanwhile, if the diagnosis cycles based on the first to N$^{th}$ voltage time series data are entirely completed, the control circuit 220 may proceed with the post-diagnosis process by referring to the diagnosis result recorded in the storage medium 221.

That is, the control circuit 220 may transmit the diagnosis result recorded in the storage medium 221 to an external device through the interface unit 330. The diagnosis result transmitted to the external device may include the identification information of the battery cell in which a voltage abnormality occurs and information regarding a time point at which the voltage abnormality of the corresponding battery cell is diagnosed. The diagnosis result transmitted to the external device may further include a warning message that the battery pack B requires detailed inspection or a diagnosis code corresponding thereto. As another alternative, the identification information of the battery cell in which a voltage abnormality occurs and detailed information regarding the time point at which the voltage abnormality of the corresponding battery cell is diagnosed may be excluded from the diagnosis result transmitted to the external device. When the external device is a vehicle controller 5, the vehicle controller 5 may output the diagnosis result through a graphical user interface on an integrated display panel mounted on the vehicle 1. When the external device is an on-board diagnosing device that is operably coupled to the interface unit 330, the on-board diagnosing device may output the diagnosis result through the display. At this time, it is desirable that the diagnosis result include a diagnosis code indicating that there is a battery cell exhibiting a voltage abnormality in the battery pack.

In another example, after diagnosing for the entire battery cell is completed, the control circuit 220 may output the diagnosis result recorded in the storage medium 221 visually or audibly through the output device 331 operably coupled to the interface unit 330. The diagnosis result output through the output device 331 may include identification information of the battery cell in which a voltage abnormality occurs and information regarding the time point at which the voltage abnormality of the corresponding battery cell is diagnosed. Alternatively, the diagnosis result output through the output device 331 may further include a warning message indicating that the battery pack B needs to be inspected or a diagnosis code corresponding thereto. As another alternative, the identification information of the battery cell in which a voltage abnormality occurs and detailed information regarding the time point at which the voltage abnormality of the corresponding battery cell is diagnosed may be excluded from the diagnosis result output through the output device 331.

When the diagnosis result is output through the output device 331, the user of the vehicle 1 may diagnose the state of the battery pack B more precisely by bringing the vehicle 1 to a service center. If phenomena such as lithium plating are actually confirmed in some of the battery cells included in the battery pack B, the battery pack B may be replaced.

Meanwhile, the battery diagnosis method according to the present disclosure may be modified as follows. In other words, the control circuit 220 may execute the diagnosis cycle in real time in association with the measurement of cell voltage before obtaining time series data for the n number of preset cell voltages.

Specifically, immediately after the first time ($t_k$) corresponding to the $k^{th}$ measurement time point and the second time ($t_{k+1}$) corresponding to the $k+1^{th}$ measurement time point have elapsed, the control circuit 220 may determine the diagnosis reference vector $\vec{v}_{refer,k}$ and the $i^{th}$ diagnosis vector $\vec{v}_{diag\_i,k}$ of the $i^{th}$ battery cell ($BC_i$) using the set of first voltages ($V_{i,k}$) measured at the first time ($t_k$) and the set of second voltages ($V_{i,k+1}$) measured at the second time ($t_{k+1}$), determine the $i^{th}$ diagnosis factor $J_{i,k}$ of the $i^{th}$ battery cell ($BC_i$) using the diagnosis reference vector $\vec{v}_{refer,k}$ and the $i^{th}$ diagnosis vector $\vec{v}_{diag\_i,k}$ of the $i^{th}$ battery cell ($BC_i$), and diagnose whether the $i^{th}$ battery cell ($BC_i$) exhibits a voltage abnormality depending on whether the $i^{th}$ diagnosis factor $J_{i,k}$ exceeds the threshold value.

The control circuit 220 may increase k by 1 from 1 to n-1 whenever the voltage is measured for the first to $N^{th}$ battery cells ($BC_1$ to $BC_N$), and whenever k increases by 1, the control circuit 220 may repeat the above real time control logic.

The real-time diagnosis logic of the control circuit 220 may be performed in synchronization with the cell voltage measurement process of each battery cell. In addition, when diagnosing for the entire battery cells are completed, the control circuit 220 may transmit the diagnosis result to an external device through the interface unit 330 as described above or output the diagnosis result through the output device 331 operably coupled to the interface unit 330 visually or audibly.

According to the embodiments described above, among the plurality of battery cells, a battery cell exhibiting a voltage abnormality may be easily identified and diagnosed through simple mathematical calculation.

According to another embodiment of the present disclosure, since the calculation method used for battery diagnosis is not complicated, a processor with high specification is not required.

According to still another embodiment of the present disclosure, the reliability of voltage abnormality diagnosis may be improved by quantitatively analyzing the difference in voltage change behavior of an abnormal battery cell compared to the average voltage change behavior of battery cells.

According to still another embodiment of the present disclosure, a battery cell that exhibit abnormal voltage behavior may be reliably identified even if the difference between voltages measured at different time points is not large.

In describing various embodiments of the present disclosure, elements named '... unit' or '... circuit' should be understood as functionally distinct elements rather than physically distinct elements. Thus, each component may be selectively integrated with other components or each component may be divided into sub-components for efficient execution of control logic(s). However, it is obvious to those skilled in the art that even if the components are integrated or divided, if the same function can be recognized, the integrated or divided components should also be interpreted as falling within the scope of the present disclosure.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Also, as many substitutions, modifications and changes may be made to the present disclosure described hereinabove by those skilled in the art without departing from the technical aspects of the present disclosure, the present disclosure is not limited by the above-described embodiments and the accompanying drawings, and all or some of the embodiments may be selectively combined to allow various modifications.

**Claims**

1. A battery diagnosis apparatus (200), comprising:

   a voltage sensing circuit (210) configured to generate voltage signals for each of first to $N^{th}$ battery cells at each of a plurality of times;
   a storage medium (221) configured to store voltage time series data; and
   a control circuit (220) operably coupled with the voltage sensing circuit (210) and the storage medium (221), wherein the control circuit (220) is configured to:

   (a) receive the voltage signals from the voltage sensing circuit (210) and record first to $N^{th}$ voltage time series data of the first to $N^{th}$ battery cells in the storage medium (221),
   (b) select a set of first voltages ($V_{i,k}$) measured at a first time and a set of second voltages ($V_{i,k+1}$) measured at a second time later the first time from the first to $N^{th}$ voltage time series data, each first voltage ($V_{i,k}$) corresponding to a respective battery of the first to Nth batteries, and each second voltage ($V_{i,k+1}$) corresponding to a respective battery of the first to Nth batteries,
   (c) determine a first average position vector ($\vec{v}_{r,k}$) having a first time coordinate and a first average voltage coordinate, and determine a second average position vector ($\vec{v}_{r,k+1}$) having a second time coordinate and a second average voltage coordinate, wherein the first average voltage coordinate is an average of the set of first voltages ($V_{i,k}$) and the second average voltage coordinate is an average of the set of second voltages ($V_{i,k+1}$),
   (d) determine a difference between the first average position vector ($\vec{v}_{r,k}$) and the second average position vector ($\vec{v}_{r,k+1}$) as a diagnosis reference vector,
   (e) for an $i^{th}$ battery cell of the first to Nth battery cells, (i) determine a first diagnosis position vector ($\vec{v}_{i,k}$) having the first time coordinate and a first voltage coordinate and determine a second diagnosis position vector ($\vec{v}_{i,k+1}$) having the second time coordinate and a second voltage coordinate, wherein the first voltage coordinate is the first voltage corresponding to the ith battery cell and the second voltage coordinate is the second voltage corresponding to the ith battery cell, (ii) determine a difference between the first diagnosis position vector ($\vec{v}_{i,k}$) and the second diagnosis position vector ($\vec{v}_{i,k+1}$) as an $i^{th}$ diagnosis vector, and (iii) determine an $i^{th}$ diagnosis factor based on a magnitude of a cross product of the diagnosis reference vector and the $i^{th}$ diagnosis vector, and
   (f) diagnose the $i^{th}$ battery cell as exhibiting a voltage abnormality in response to the $i^{th}$ diagnosis factor exceeding a threshold value.

2. The battery diagnosis apparatus according to claim 1,

   wherein the average of the set of first voltages ($V_{i,k}$) is an arithmetic mean value or a median value of the set of first voltages, and
   wherein the average of the set of second voltages ($V_{i,k+1}$) is an arithmetic mean value or a median value of the set of second voltages.

3. The battery diagnosis apparatus according to claim 1,

   wherein the average of the set of first voltages ($V_{i,k}$) is an arithmetic mean value or a median value of voltage values within a standard deviation of $\beta$ sigma among voltage values included in the set of first voltages, and
   wherein the average of the set of second voltages ($V_{i,k+1}$) is an arithmetic average value or a median value of voltage values within the standard deviation of $\beta$ sigma among voltage values included in the set of second voltages, wherein $\beta$ is a value between 1 and 3.

4. The battery diagnosis apparatus according to claim 1,

wherein the control circuit (220) is configured to:

determine the first diagnosis position vector ($\vec{v}_{i,k}$), the second diagnosis position vector ($\vec{v}_{i,k+1}$), and the $i^{th}$ diagnosis factor for each of the first to Nth battery cells, and

set the threshold value at a scaled average of the determined $i^{th}$ diagnosis factors for the first through Nth battery cells, wherein the scaled average is scaled by a predetermined factor $\alpha$ having a value between 1 and 10.

5. The battery diagnosis apparatus according to claim 1,
wherein a time interval between the first time and the second time is an integer multiple of a voltage measurement period.

6. The battery diagnosis apparatus according to claim 1, further comprising:

an interface unit (330) operably coupled with the control circuit (220) to support communication with an external device,
wherein the control circuit (220) is configured to transmit a diagnosis result indicating the voltage abnormality of the ith battery cell to the external device through the interface (330).

7. The battery diagnosis apparatus according to claim 1, further comprising:

an interface unit (330) operably coupled with the control circuit (220); and
an output device (331) operably coupled with the interface unit (330),
wherein the control circuit (220) is configured to at least one of visually or audibly output a diagnosis result indicating the voltage abnormality of the ith battery cell through the output device (331).

8. A battery pack, comprising the battery diagnosis apparatus according to any one of claims 1 to 7.

9. A vehicle, comprising the battery pack according to claim 8.

10. A battery diagnosis method, comprising:

(a) generating first to $N^{th}$ voltage time series data of first to $N^{th}$ battery cells from voltage signals received from a voltage sensing circuit (210) and recording the first to $N^{th}$ voltage time series data in a storage medium (221);
(b) selecting a set of first voltages ($V_{i,k}$) measured at a first time and a set of second voltages ($V_{i,k+1}$) measured at a second time later the first time from the first to $N^{th}$ voltage time series data, each first voltage ($V_{i,k}$) corresponding to a respective battery of the first to Nth batteries, and each second voltage ($V_{i,k+1}$) corresponding to a respective battery of the first to Nth batteries;
(c) determining a first average position vector ($\vec{v}_{r,k}$) having a first time coordinate and a first average voltage coordinate and determining a second average position vector ($\vec{v}_{r,k+1}$) having a second time coordinate and a second average voltage coordinate, wherein the first average voltage coordinate is an average of the set of first voltages ($V_{i,k}$) and the second average voltage coordinate is an average of the set of second voltages ($V_{i,k+1}$),
(d) determining a difference between the first average position vector ($\vec{v}_{r,k}$) and the second average position vector ($\vec{v}_{r,k+1}$) as a diagnosis reference vector,
(e) for an $i^{th}$ battery cell of the first to Nth battery cells, (i) determining a first diagnosis position vector ($\vec{v}_{i,k}$) and having the first time coordinate and a first voltage coordinate and determining a second diagnosis position vector ($\vec{v}_{i,k+1}$) having the second time coordinate and a second voltage coordinate, wherein the first voltage coordinate is the first voltage corresponding to the ith battery cell and the second voltage coordinate is the second voltage corresponding to the ith battery cell, (ii) determining a difference between the first diagnosis position vector ($\vec{v}_{i,k}$) and the second diagnosis position vector ($\vec{v}_{i,k-1}$) as an $i^{th}$ diagnosis vector, and (iii) determining an $i^{th}$ diagnosis factor based on a magnitude of a cross product of the diagnosis reference vector and the $i^{th}$ diagnosis vector; and
(f) diagnosing the $i^{th}$ battery cell as exhibiting a voltage abnormality in response to the $i^{th}$ diagnosis factor exceeding a threshold value.

11. The battery diagnosis method according to claim 10, further comprising:

setting an arithmetic mean value or a median value of the set of first voltages ($V_{i,k}$) as the average of the set of first voltages, and
setting an arithmetic mean value or a median value of the set of second voltages ($V_{i,k+1}$) as the average of the set of second voltages.

12. The battery diagnosis method according to claim 10, wherein the step (c) includes:

setting an arithmetic mean value or a median value of first voltages ($V_{i,k}$) within $\beta$ sigma as the average of the set of first voltages, and
setting an arithmetic mean value or a median value of second voltages ($V_{i,k+1}$) within a standard deviation of $\beta$ sigma as the average of the set of second voltages, wherein $\beta$ is a value between 1 and 3.

13. The battery diagnosis method according to claim 11, further comprising:

determining the first diagnosis position vector ($\vec{v}_{i,k}$), the second diagnosis position vector ($\vec{v}_{i,k-1}$), and the $i^{th}$ diagnosis factor for each of the first to Nth battery cells
set the threshold value at a scaled average of the determined $i^{th}$ diagnosis factors for the first through Nth battery cells, wherein the scaled average is scaled by a predetermined factor $\alpha$ having a value between 1 and 10.

14. The battery diagnosis method according to claim 10,
wherein a time interval between the first time and the second time is an integer multiple of a voltage measurement period.

15. The battery diagnosis method according to claim 10, further comprising:

transmitting a diagnosis result indicating the voltage abnormality of the ith battery cell to an external device through an interface unit (330); or
visually or audibly outputting the diagnosis result indicating the voltage abnormality of the ith battery cell through an output device (331).

## Patentansprüche

1. Batteriediagnosevorrichtung (200), umfassend:

eine Spannungserfassungsschaltung (210), die konfiguriert ist, um Spannungssignale für jede einer ersten bis N-ten Batteriezelle zu jedem einer Vielzahl von Zeitpunkten zu erzeugen;
ein Speichermedium (221), das konfiguriert ist, um Spannungszeitreihendaten zu speichern; und
eine Steuerschaltung (220), die funktionsfähig mit der Spannungserfassungsschaltung (210) und dem Speichermedium (221) gekoppelt ist,
wobei die Steuerschaltung (220) konfiguriert ist zum:

(a) Empfangen der Spannungssignale von der Spannungserfassungsschaltung (210) und Aufzeichnen von Spannungszeitreihendaten der ersten bis N-ten Batteriezelle in dem Speichermedium (221),
(b) Auswählen eines Satzes von ersten Spannungen ($V_{i,k}$), die zu einem ersten Zeitpunkt gemessen wurden, und eines Satzes von zweiten Spannungen ($V_{i,k+1}$), die zu einem zweiten Zeitpunkt später als der erste Zeitpunkt gemessen wurden, aus den Spannungszeitreihendaten der ersten bis N-ten Batteriezelle, wobei jede erste Spannung ($V_{i,k}$) einer jeweiligen Batterie der ersten bis N-ten Batterien entspricht, und jede zweite Spannung ($V_{i,k+1}$) einer jeweiligen Batterie der ersten bis N-ten Batterien entspricht,
(c) Bestimmen eines ersten mittleren Positionsvektors ($\vec{v}_{r,k}$) mit einer ersten Zeitkoordinate und einer ersten mittleren Spannungskoordinate und Bestimmen eines zweiten mittleren Positionsvektors ($\vec{v}_{r,k+1}$) mit einer zweiten Zeitkoordinate und einer zweiten mittleren Spannungskoordinate, wobei die erste mittlere Spannungskoordinate ein Mittelwert des Satzes von ersten Spannungen ($V_{i,k}$) ist und die zweite mittlere Spannungskoordinate ein Mittelwert des Satzes von zweiten Spannungen ($V_{i,k+1}$) ist,
(d) Bestimmen einer Differenz zwischen dem ersten mittleren Positionsvektor ($\vec{v}_{r,k}$) und dem zweiten mittleren Positionsvektor ($\vec{v}_{r,k+1}$) als einen Diagnosereferenzvektor,
(e) für eine i-te Batteriezelle der ersten bis N-ten Batteriezellen, (i) Bestimmen eines ersten Diagnosepositionsvektors ($\vec{v}_{i,k}$) mit der ersten Zeitkoordinate und einer ersten Spannungskoordinate und Bestimmen eines zweiten Diagnosepositionsvektors ($\vec{v}_{i,k+1}$) mit der zweiten Zeitkoordinate und einer zweiten Spannungskoordinate, wobei die erste Spannungskoordinate die erste Spannung ist, die der i-ten Batteriezelle entspricht, und die zweite Spannungskoordinate die zweite Spannung ist, die der i-ten Batteriezelle entspricht, (ii) Bestimmen einer Differenz zwischen dem ersten Diagnosepositionsvektor ($\vec{v}_{i,k}$) und dem zweiten Diagnosepositionsvektor ($\vec{v}_{i,k+1}$) als einen i-ten Diagnosevektor, und (iii) Bestimmen eines i-ten Diagnosefaktors basierend auf einer Größe eines Kreuzprodukts des Diagnosereferenzvektors und des i-ten Diagnosevektors, und

(f) Diagnostizieren, dass die i-te Batteriezelle eine Spannungsanomalie aufweist, als Reaktion darauf, dass der i-te Diagnosefaktor einen Schwellenwert überschreitet.

2. Batteriediagnosevorrichtung nach Anspruch 1,

wobei der Mittelwert des Satzes von ersten Spannungen ($V_{i,k}$) ein arithmetischer Mittelwert oder ein Medianwert des Satzes von ersten Spannungen ist, und
wobei der Mittelwert des Satzes von zweiten Spannungen ($V_{i,k+1}$) ein arithmetischer Mittelwert oder ein Medianwert des Satzes von zweiten Spannungen ist.

3. Batteriediagnosevorrichtung nach Anspruch 1,

wobei der Mittelwert des Satzes von ersten Spannungen ($V_{i,k}$) ein arithmetischer Mittelwert oder ein Medianwert von Spannungswerten innerhalb einer Standardabweichung von $\beta$ Sigma unter den Spannungswerten ist, die in dem Satz von ersten Spannungen enthalten sind, und
wobei der Mittelwert des Satzes von zweiten Spannungen ($V_{i,k+1}$) ein arithmetischer Mittelwert oder ein Medianwert von Spannungswerten innerhalb der Standardabweichung von $\beta$ Sigma unter den Spannungswerten ist, die in dem Satz von zweiten Spannungen enthalten sind, wobei $\beta$ ein Wert zwischen 1 und 3 ist.

4. Batteriediagnosevorrichtung nach Anspruch 1,
wobei die Steuerschaltung (220) konfiguriert ist zum:

Bestimmen des ersten Diagnosepositionsvektors ($\vec{v}_{i,k}$), des zweiten Diagnosepositionsvektors ($\vec{v}_{i,k+1}$) und des i-ten Diagnosefaktors für jede der ersten bis N-ten Batteriezellen, und
Einstellen des Schwellenwerts auf einen skalierten Mittelwert der bestimmten i-ten Diagnosefaktoren für die ersten bis N-ten Batteriezellen, wobei der skalierte Mittelwert durch einen vorbestimmten Faktor $\alpha$ mit einem Wert zwischen 1 und 10 skaliert wird.

5. Batteriediagnosevorrichtung nach Anspruch 1,
wobei ein Zeitintervall zwischen dem ersten Zeitpunkt und dem zweiten Zeitpunkt ein ganzzahliges Vielfaches einer Spannungsmessperiode ist.

6. Batteriediagnosevorrichtung nach Anspruch 1, ferner umfassend:

eine Schnittstelleneinheit (330), die funktionsfähig mit der Steuerschaltung (220) gekoppelt ist, um die Kommunikation mit einem externen Gerät zu unterstützen,
wobei die Steuerschaltung (220) konfiguriert ist, um ein Diagnoseergebnis, das die Spannungsanomalie der i-ten Batteriezelle anzeigt, über die Schnittstelle (330) an das externe Gerät zu übertragen.

7. Batteriediagnosevorrichtung nach Anspruch 1, ferner umfassend:

eine Schnittstelleneinheit (330), die funktionsfähig mit der Steuerschaltung (220) gekoppelt ist; und
ein Ausgabegerät (331), das funktionsfähig mit der Schnittstelleneinheit (330) gekoppelt ist,
wobei die Steuerschaltung (220) konfiguriert ist, um ein Diagnoseergebnis visuell und/oder akustisch auszugeben, das die Spannungsanomalie der i-ten Batteriezelle über das Ausgabegerät (331) anzeigt.

8. Batteriepack, umfassend die Batteriediagnosevorrichtung nach einem der Ansprüche 1 bis 7.

9. Fahrzeug, umfassend den Batteriepack nach Anspruch 8.

10. Batteriediagnoseverfahren, umfassend:

(a) Erzeugen von ersten bis N-ten Spannungszeitreihendaten der ersten bis N-ten Batteriezelle aus Spannungssignalen, die von einer Spannungserfassungsschaltung (210) empfangen werden, und Aufzeichnen der ersten bis N-ten Spannungszeitreihendaten in einem Speichermedium (221);

(b) Auswählen eines Satzes von ersten Spannungen ($V_{i,k}$), die zu einem ersten Zeitpunkt gemessen wurden, und eines Satzes von zweiten Spannungen ($V_{i,k+1}$), die zu einem zweiten Zeitpunkt später als der erste Zeitpunkt gemessen wurden, aus den ersten bis N-ten Spannungszeitreihendaten, wobei jede erste Spannung ($V_{i,k}$) einer jeweiligen Batterie der ersten bis N-ten Batterien entspricht, und jede zweite Spannung ($V_{i,k+1}$) einer jeweiligen Batterie der ersten bis N-ten Batterien entspricht;

(c) Bestimmen eines ersten mittleren Positionsvektors ($\vec{v}_{r,k}$) mit einer ersten Zeitkoordinate und einer ersten mittleren Spannungskoordinate und Bestimmen eines zweiten mittleren Positionsvektors ($\vec{v}_{r,k+1}$) mit einer zweiten Zeitkoordinate und einer zweiten mittleren Spannungskoordinate, wobei die erste mittlere Spannungskoordinate ein Mittelwert des Satzes von ersten Spannungen ($V_{i,k}$) ist und die zweite mittlere Spannungskoordinate ein Mittelwert des Satzes von zweiten Spannungen ($V_{i,k+1}$) ist,

(d) Bestimmen einer Differenz zwischen dem ersten mittleren Positionsvektor ($\vec{v}_{r,k}$) und dem zweiten mittleren Positionsvektor ($\vec{v}_{r,k+1}$) als einen Diagnosereferenzvektor,

(e) für eine i-te Batteriezelle der ersten bis N-ten Batteriezellen, (i) Bestimmen eines ersten Diagnosepositionsvektors ($\vec{v}_{i,k}$) mit der ersten Zeitkoordinate und einer ersten Spannungskoordinate und Bestimmen eines zweiten Diagnosepositionsvektors ($\vec{v}_{r,k+1}$) mit der zweiten Zeitkoordinate und einer zweiten Spannungskoordinate, wobei die erste Spannungskoordinate die erste Spannung ist, die der i-ten Batteriezelle entspricht, und die zweite Spannungskoordinate die zweite Spannung ist, die der i-ten Batteriezelle entspricht, (ii) Bestimmen einer Differenz zwischen dem ersten Diagnosepositionsvektor ($\vec{v}_{i,k}$) und dem zweiten Diagnosepositionsvektor ($\vec{v}_{i,k+1}$) als einen i-ten Diagnosevektor; und (iii) Bestimmen eines i-ten Diagnosefaktors basierend auf einer Größe eines Kreuzprodukts des Diagnosereferenzvektors und des i-ten Diagnosevektors; und

(f) Diagnostizieren, dass die i-te Batteriezelle eine Spannungsanomalie aufweist, als Reaktion darauf, dass der i-te Diagnosefaktor einen Schwellenwert überschreitet.

**11.** Batteriediagnoseverfahren nach Anspruch 10, ferner umfassend:

Einstellen eines arithmetischen Mittelwerts oder eines Medianwerts des Satzes von ersten Spannungen ($V_{i,k}$) als Mittelwert des Satzes von ersten Spannungen, und

Einstellen eines arithmetischen Mittelwerts oder eines Medianwerts des Satzes von zweiten Spannungen ($V_{i,k+1}$) als Mittelwert des Satzes von zweiten Spannungen.

**12.** Batteriediagnoseverfahren nach Anspruch 10, wobei der Schritt (c) einschließt:

Einstellen eines arithmetischen Mittelwerts oder eines Medianwerts von ersten Spannungen ($V_{i,k}$) innerhalb von $\beta$ Sigma als Mittelwert des Satzes von ersten Spannungen, und

Einstellen eines arithmetischen Mittelwerts oder eines Medianwerts von zweiten Spannungen ($V_{i,k+1}$) innerhalb einer Standardabweichung von $\beta$ Sigma als Mittelwert des Satzes von zweiten Spannungen, wobei $\beta$ ein Wert zwischen 1 und 3 ist.

**13.** Batteriediagnoseverfahren nach Anspruch 11, ferner umfassend:

Bestimmen des ersten Diagnosepositionsvektors ($\vec{v}_{i,k}$), des zweiten Diagnosepositionsvektors ($\vec{v}_{i,k+1}$) und des i-ten Diagnosefaktors für jede der ersten bis N-ten Batteriezellen, Einstellen des Schwellenwerts auf einen skalierten Mittelwert der bestimmten i-ten Diagnosefaktoren für die ersten bis N-ten Batteriezellen, wobei der skalierte Mittelwert durch einen vorbestimmten Faktor $\alpha$ mit einem Wert zwischen 1 und 10 skaliert wird.

**14.** Batteriediagnoseverfahren nach Anspruch 10, wobei ein Zeitintervall zwischen dem ersten Zeitpunkt und dem zweiten Zeitpunkt ein ganzzahliges Vielfaches einer Spannungsmessperiode ist.

**15.** Batteriediagnoseverfahren nach Anspruch 10, ferner umfassend:

Übertragen eines Diagnoseergebnisses, das die Spannungsanomalie der i-ten Batteriezelle anzeigt, an ein externes Gerät über eine Schnittstelleneinheit (330); oder

visuelles oder akustisches Ausgeben des Diagnoseergebnisses, das die Spannungsanomalie der i-ten Batteriezelle anzeigt, über ein Ausgabegerät (331).

# EP 4 553 515 B1

**Revendications**

1.  Appareil de diagnostic de batterie (200), comprenant :

    un circuit de détection de tension (210) configuré pour générer des signaux de tension pour chacune d'une première à une $N^{ième}$ cellules de batterie à chacun d'une pluralité d'instants ;
    un support de stockage (221) configuré pour stocker des données de séries temporelles de tension ; et
    un circuit de commande (220) couplé de manière fonctionnelle au circuit de détection de tension (210) et au support de stockage (221),
    dans lequel le circuit de commande (220) est configuré pour :

    (a) recevoir les signaux de tension du circuit de détection de tension (210) et enregistrer les données de séries temporelles de tension de la première à la $N^{ième}$ cellules de batterie dans le support de stockage (221),
    (b) sélectionner un ensemble de premières tensions ($V_{i,k}$) mesurées à un premier instant et un ensemble de secondes tensions ($V_{i,k+1}$) mesurées à un second instant postérieur au premier instant à partir des données de séries temporelles de tension de la première à la $N^{ième}$ cellules de batterie, chaque première tension ($V_{i,k}$) correspondant à une batterie respective des première à $N^{ième}$ batteries, et chaque seconde tension ($V_{i,k+1}$) correspondant à une batterie respective des première à $N^{ième}$ batteries,
    (c) déterminer un premier vecteur de position moyenne ($v_{r,k}$) ayant une première coordonnée de temps et une première coordonnée de tension moyenne, et déterminer un second vecteur de position moyenne ($v_{r,k+1}$) ayant une seconde coordonnée de temps et une seconde coordonnée de tension moyenne, dans lequel la première coordonnée de tension moyenne est une moyenne de l'ensemble de premières tensions ($V_{i,k}$) et la seconde coordonnée de tension moyenne est une moyenne de l'ensemble de secondes tensions ($V_{i,k+1}$),
    (d) déterminer une différence entre le premier vecteur de position moyenne ($v_{r,k}$) et le second vecteur de position moyenne ($v_{r,k+1}$) comme un vecteur de référence de diagnostic,
    (e) pour une $i^{ème}$ cellule de batterie des première à $N^{ième}$ cellules de batterie, (i) déterminer un premier vecteur de position de diagnostic ($v_{i,k}$) ayant la première coordonnée de temps et une première coordonnée de tension et déterminer un second vecteur de position de diagnostic ($v_{i,k+1}$) ayant la seconde coordonnée de temps et une seconde coordonnée de tension, dans lequel la première coordonnée de tension est la première tension correspondant à la $i^{ème}$ cellule de batterie et la seconde coordonnée de tension est la seconde tension correspondant à la $i^{ème}$ cellule de batterie, (ii) déterminer une différence entre le premier vecteur de position de diagnostic ($v_{i,k}$) et le second vecteur de position de diagnostic ($v_{i,k+1}$) comme un $i^{ème}$ vecteur de diagnostic, et (iii) déterminer un $i^{ème}$ facteur de diagnostic basé sur une magnitude d'un produit vectoriel du vecteur de référence de diagnostic et du $i^{ème}$ vecteur de diagnostic, et
    (f) diagnostiquer la $i^{ème}$ cellule de batterie comme présentant une anomalie de tension en réponse au fait que le $i^{ème}$ facteur de diagnostic dépasse une valeur de seuil.

2.  L'appareil de diagnostic de batterie selon la revendication 1,

    dans lequel la moyenne de l'ensemble de premières tensions ($V_{i,k}$) est une valeur moyenne arithmétique ou une valeur médiane de l'ensemble de premières tensions, et
    dans lequel la moyenne de l'ensemble de secondes tensions ($V_{i,k+1}$) est une valeur moyenne arithmétique ou une valeur médiane de l'ensemble de secondes tensions.

3.  L'appareil de diagnostic de batterie selon la revendication 1,

    dans lequel la moyenne de l'ensemble de premières tensions ($V_{i,k}$) est une valeur moyenne arithmétique ou une valeur médiane de valeurs de tension à l'intérieur d'un écart-type de $\beta$ sigma parmi les valeurs de tension incluses dans l'ensemble de premières tensions, et
    dans lequel la moyenne de l'ensemble de secondes tensions ($V_{i,k+1}$) est une valeur moyenne arithmétique ou une valeur médiane de valeurs de tension à l'intérieur de l'écart-type de $\beta$ sigma parmi les valeurs de tension incluses dans l'ensemble de secondes tensions, où $\beta$ est une valeur entre 1 et 3.

4.  L'appareil de diagnostic de batterie selon la revendication 1,
    dans lequel le circuit de commande (220) est configuré pour :

    déterminer le premier vecteur de position de diagnostic ($v_{i,k}$), le second vecteur de position de diagnostic ($v_{i,k+1}$),

et le $i^{\text{ème}}$ facteur de diagnostic pour chacune des première à $N^{\text{ième}}$ cellules de batterie, et

définir la valeur de seuil à une moyenne mise à l'échelle des $i^{\text{èmes}}$ facteurs de diagnostic déterminés pour les première à $N^{\text{ième}}$ cellules de batterie, dans lequel la moyenne mise à l'échelle est mise à l'échelle par un facteur prédéterminé $\alpha$ ayant une valeur entre 1 et 10.

5. L'appareil de diagnostic de batterie selon la revendication 1,
dans lequel un intervalle de temps entre le premier instant et le second instant est un multiple entier d'une période de mesure de tension.

6. L'appareil de diagnostic de batterie selon la revendication 1, comprenant en outre :

une unité d'interface (330) couplée de manière fonctionnelle avec le circuit de commande (220) pour supporter la communication avec un dispositif externe,
dans lequel le circuit de commande (220) est configuré pour transmettre un résultat de diagnostic indiquant l'anomalie de tension de la $i^{\text{ème}}$ cellule de batterie au dispositif externe par l'intermédiaire de l'interface (330).

7. L'appareil de diagnostic de batterie selon la revendication 1, comprenant en outre :

une unité d'interface (330) couplée de manière fonctionnelle avec le circuit de commande (220) ; et
un dispositif de sortie (331) couplé de manière fonctionnelle avec l'unité d'interface (330),
dans lequel le circuit de commande (220) est configuré pour délivrer en sortie au moins visuellement ou audiblement un résultat de diagnostic indiquant l'anomalie de tension de la $i^{\text{ème}}$ cellule de batterie par l'intermédiaire du dispositif de sortie (331).

8. Un bloc-batterie, comprenant l'appareil de diagnostic de batterie selon l'une quelconque des revendications 1 à 7.

9. Un véhicule, comprenant le bloc-batterie selon la revendication 8.

10. Un procédé de diagnostic de batterie, comprenant :

(a) la génération de données de séries temporelles de tension de la première à la $N^{\text{ième}}$ cellules de batterie à partir de signaux de tension reçus d'un circuit de détection de tension (210) et l'enregistrement des données de séries temporelles de tension de la première à la $N^{\text{ième}}$ cellules de batterie dans un support de stockage (221) ;
(b) la sélection d'un ensemble de premières tensions ($V_{i,\,k}$) mesurées à un premier instant et d'un ensemble de secondes tensions ($V_{i,\,k+1}$) mesurées à un second instant postérieur au premier instant à partir des données de séries temporelles de tension de la première à la $N^{\text{ième}}$ cellules de batterie, chaque première tension ($V_{i,\,k}$) correspondant à une batterie respective des première à $N^{\text{ième}}$ batteries, et chaque seconde tension ($V_{i,\,k+1}$) correspondant à une batterie respective des première à $N^{\text{ième}}$ batteries ;
(c) la détermination d'un premier vecteur de position moyenne ($v_{r,k}$) ayant une première coordonnée de temps et une première coordonnée de tension moyenne et la détermination d'un second vecteur de position moyenne ($v_{r,k+1}$) ayant une seconde coordonnée de temps et une seconde coordonnée de tension moyenne, dans lequel la première coordonnée de tension moyenne est une moyenne de l'ensemble de premières tensions ($V_{i,\,k}$) et la seconde coordonnée de tension moyenne est une moyenne de l'ensemble de secondes tensions ($V_{i,\,k+1}$),
(d) la détermination d'une différence entre le premier vecteur de position moyenne ($v_{r,k}$) et le second vecteur de position moyenne ($v_{r,k+1}$) comme un vecteur de référence de diagnostic,
(e) pour une $i^{\text{ème}}$ cellule de batterie des première à $N^{\text{ième}}$ cellules de batterie, (i) la détermination d'un premier vecteur de position de diagnostic ($v_{i,k}$) et ayant la première coordonnée de temps et une première coordonnée de tension et la détermination d'un second vecteur de position de diagnostic ($v_{i,k+1}$) ayant la seconde coordonnée de temps et une seconde coordonnée de tension, dans lequel la première coordonnée de tension est la première tension correspondant à la $i^{\text{ème}}$ cellule de batterie et la seconde coordonnée de tension est la seconde tension correspondant à la $i^{\text{ème}}$ cellule de batterie, (ii) la détermination d'une différence entre le premier vecteur de position de diagnostic ($v_{i,k}$) et le second vecteur de position de diagnostic ($v_{i,k+1}$) comme un $i^{\text{ème}}$ vecteur de diagnostic, et (iii) la détermination d'un $i^{\text{ème}}$ facteur de diagnostic basé sur une magnitude d'un produit vectoriel du vecteur de référence de diagnostic et du $i^{\text{ème}}$ vecteur de diagnostic ; et
(f) le diagnostic de la $i^{\text{ème}}$ cellule de batterie comme présentant une anomalie de tension en réponse au fait que le $i^{\text{ème}}$ facteur de diagnostic dépasse une valeur de seuil.

11. Le procédé de diagnostic de batterie selon la revendication 10, comprenant en outre :

la définition d'une valeur moyenne arithmétique ou d'une valeur médiane de l'ensemble de premières tensions ($V_{i, k}$) comme la moyenne de l'ensemble de premières tensions, et

la définition d'une valeur moyenne arithmétique ou d'une valeur médiane de l'ensemble de secondes tensions ($V_{i, k+1}$) comme la moyenne de l'ensemble de secondes tensions.

12. Le procédé de diagnostic de batterie selon la revendication 10, dans lequel l'étape (c) inclut :

la définition d'une valeur moyenne arithmétique ou d'une valeur médiane des premières tensions ($V_{i, k}$) à l'intérieur de $\beta$ sigma comme la moyenne de l'ensemble de premières tensions, et

la définition d'une valeur moyenne arithmétique ou d'une valeur médiane des secondes tensions ($V_{i, k+1}$) à l'intérieur d'un écart-type de $\beta$ sigma comme la moyenne de l'ensemble de secondes tensions, où $\beta$ est une valeur entre 1 et 3.

13. Le procédé de diagnostic de batterie selon la revendication 11, comprenant en outre :

la détermination du premier vecteur de position de diagnostic ($v_{i,k}$), du second vecteur de position de diagnostic ($v_{i,k+1}$), et du $i^{ème}$ facteur de diagnostic pour chacune des première à $N^{ième}$ cellules de batterie

la définition de la valeur de seuil à une moyenne mise à l'échelle des $i^{èmes}$ facteurs de diagnostic déterminés pour les première à $N^{ième}$ cellules de batterie, dans lequel la moyenne mise à l'échelle est mise à l'échelle par un facteur prédéterminé $\alpha$ ayant une valeur entre 1 et 10.

14. Le procédé de diagnostic de batterie selon la revendication 10, dans lequel un intervalle de temps entre le premier instant et le second instant est un multiple entier d'une période de mesure de tension.

15. Le procédé de diagnostic de batterie selon la revendication 10, comprenant en outre :

la transmission d'un résultat de diagnostic indiquant l'anomalie de tension de la $i^{ème}$ cellule de batterie à un dispositif externe par l'intermédiaire d'une unité d'interface (330) ; ou

la délivrance en sortie visuelle ou audible du résultat de diagnostic indiquant l'anomalie de tension de la $i^{ème}$ cellule de batterie par l'intermédiaire d'un dispositif de sortie (331).

FIG. 1

FIG. 2a

FIG. 2b

FIG. 2c

FIG. 3

START

S10
GENERATE AND STORE FIRST TO N$^{TH}$ VOLTAGE TIME SERIES DATA

S20
INITIALIZE DIAGNOSIS CYCLE INDEX

S30
SELECT SET OF FIRST VOLTAGES ($V_{i,k}$) AND SET OF SECOND VOLTAGES ($V_{i,k+1}$) FROM FIRST TO N$^{TH}$ VOLTAGE TIME SERIES DATA

S40
DETERMINE FIRST AVERAGE POSITION VECTOR $\vec{v}_{r,k}$ AND SECOND AVERAGE POSITION VECTOR $\vec{v}_{r,k+1}$

S50
DETERMINE DIAGNOSIS REFERENCE VECTOR $\vec{v}_{refer,k}$

S60
INITIALIZE CELL INDEX i

S70
DETERMINE FIRST DIAGNOSIS POSITION VECTOR $\vec{v}_{i,k}$ AND SECOND DIAGNOSIS POSITION VECTOR $\vec{v}_{i,k+1}$

S80
DETERMINE i$^{TH}$ DIAGNOSIS VECTOR $\vec{v}_{diag\_i,k}$

S90
DETERMINE i$^{TH}$ DIAGNOSIS FACTOR $J_{i,k}$

S100
$J_{i,k}$ > THRESHOLD VALUE?  —NO

YES

S110
RECORD DIAGNOSIS RESULT

S130
INCREASE CELL INDEX i BY 1  —NO—

S120
IS i EQUAL TO N?

YES

S150
INCREASE DIAGNOSIS CYCLE INDEX BY 1  —NO—

S140
IS k EQUAL TO n-1?

YES

END

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220122317

- CN 113777515